# EUROPEAN PATENT APPLICATION

(11) **EP 4 546 990 A1**
(43) Date of publication of application: **30.04.2025**
(21) Application number: 24205973.1
(22) Date of filing: 10.10.2024
(51) Int. Cl.: H10K 59/121, H10K 59/122, H10K 59/38, H10K 59/80

(54) **LIGHT EMITTING DISPLAY DEVICE**

(30) Priority: 27.10.2023 KR 20230145950
(71) Applicant: Samsung Display Co., Ltd., Gyeonggi-do 17113 (KR)
(72) Inventor: Kim, Chan Young, Yongin-si, Gyeonggi-do (KR); Cho, Seong Min, Yongin-si, Gyeonggi-do (KR); Kang, Sang Woo, Yongin-si, Gyeonggi-do (KR); Im, Choong Youl, Yongin-si, Gyeonggi-do (KR); Choi, Kook Hyun, Yongin-si, Gyeonggi-do (KR); Choi, Beohm Rock, Yongin-si, Gyeonggi-do (KR); Hwang, Seong-Yong, Yongin-si, Gyeonggi-do (KR)
(74) Representative: Gulde & Partner

(57) **Abstract**

A light emitting display device includes: a display panel includes: a display area and a component area surrounded by the display area and including a plurality of optical sensor areas (OPS), and an optical element located on a rear surface of the component area. The display area includes: a pixel defining layer (380) defining an opening that overlaps an anode, a cathode covering the pixel defining layer, an encapsulation layer (400) located on a top of the cathode, a color filter (230B, 230R, 230G) positioned on the encapsulation layer and overlapping the opening of the pixel defining layer. The color filter and the pixel defining layer each have an additional opening (OPCF-1, OP-1) corresponding to the optical sensor area, and the additional opening of the color filter (OPCF-1) is narrower than the additional opening (OP-1) of the pixel defining layer, so that the pixel defining layer is obscured by the color filter in the optical sensor area.

## Description

### BACKGROUND

### 1. Field

The present disclosure relates to a light emitting display device, wherein the light emitting display device has a sensor on a back surface of a display area.

### 2. Description of the Related Art

A display device is a device that displays a screen and includes a liquid crystal display (LCD) and an organic light emitting diode (OLED).

These display devices are used in various electronic devices such as mobile phones, navigation devices, digital cameras, electronic books, portable game consoles, and other terminals.

A display device, such as an organic light emitting display device, may have a structure that can be bent or folded using a flexible substrate.

In addition, in small electronic devices such as mobile phones, optical elements such as cameras and optical sensors are formed in the bezel area around the display area. However, as the size of the display screen increases, the size of the area surrounding the display area gradually decreases, and camera technology is being developed that allows optical sensors to be positioned on the back of the display area.

### SUMMARY

Embodiments are intended to prevent the component area located in front of the sensor in the light emitting display device from being visible when external light is reflected.

Embodiments are intended to ensure that the component area located in front of the sensor in the light emitting display device is not recognized as being distinguished from the surrounding display area.

A light emitting display device according to an embodiment includes: a display panel including a display area and a component area, wherein the component area is surrounded by the display area and including a plurality of optical sensor areas; and an optical element located on a rear surface of the component area. The display area includes a pixel defining layer defining an opening that overlaps an anode in a plan view, a cathode covering the pixel defining layer, an encapsulation layer located on top of the cathode, and a color filter positioned on the encapsulation layer and overlapping the opening of the pixel defining layer in the plan view, where the color filter and the pixel defining layer each extend to the component area and define an additional opening therein corresponding to each optical sensor area of the plurality of optical sensor areas, and an area of the additional opening of the color filter which is smaller than an area of the additional opening of the pixel defining layer in the plan view such that a portion the pixel defining layer is obscured by the color filter in the plan view in the each optical sensor area.

A portion of the cathode located on an inclined surface of the pixel defining layer in the each optical sensor area may be obscured by the color filter in the plan view.

The gap between the additional opening of the pixel defining layer and the additional opening of the color filter may be equal to or more than 1 micrometer (µm) and equal to or less than 2 µm, preferably equal to or more than 1,2 µm and equal to or less than 1,8 µm, equal to or more than 1, 4 µm and equal to or less than 1,6 µm.

The pixel defining layer may be a black pixel defining layer, and a light blocking layer may not be located on top of the black pixel defining layer.

The color filter may include a red-color filter and a blue-color filter, each of the red-color filter and the blue-color filter may define an additional opening therein, and an area of the additional opening of the color filter located at a lower portion of the red-color filter and the blue-color filter may be smaller than an area of the additional opening of the color filter located at the top of the red-color filter and the blue-color filter in the plan view.

The color filter may include a red-color filter and a blue-color filter, and the red-color filter and the blue-color filter may each define an additional opening therein, and an area of the color filter located at the top of the red-color filter and the blue-color filter may have a structure that covers the side of the color filter located at the bottom.

An area of the additional opening of the upper color filter among the red-color filter and the blue-color filter may be smaller than an area of the additional opening of the lower color filter in the plan view.

The color filter may include a red-color filter, a green-color filter, and a blue-color filter, where the red-color filter, the green-color filter, and the blue-color filter each define an additional opening therein, and the red-color filter and the green-color filter may each define an additional opening therein, the additional opening of the lowermost color filter among the red color filter, the green-color filter, and the blue-color filter may be narrowest, and the additional opening of the uppermost color filter among the red-color filter, the green-color filter, and the blue-color filter can be made as the largest in a cross-sectional view.

The color filter may include a red-color filter, a green-color filter, and a blue-color filter, where the red-color filter, the green-color filter, and the blue-color filter may each define an additional opening therein, and at least two of the additional openings of the red-color filter, the green-color filter, and the blue-color filter may have different shapes from each other in the plan view.

The component area may be divided into a plurality of component areas, and the component area located close to the display area may have a smaller density or size of the optical sensor area than the component area located relatively far from the display area.

The component area may have a 1-1 component area, a 1-2 component area, and a 1-3 component area, the 1-3 component area may be located closest to the display area, and the 1-1 component area may be located furthest from the display area, the density or size of the optical sensor area of the 1-1 component area may be the largest of the 1-1 component area, the 1-2 component area, and the 1-3 component area, and the density or size of the optical sensor area of the 1-2 component area may be an intermediate value, and the density or size of the optical sensor area of the 1-3 component area may have the smallest value.

A buffer area may be located between the component area and the display area.

According to one embodiment, the light emitting display device includes a display panel including a display area and a component area, where the component area is surrounded by the display area and including multiple optical sensor areas; and an optical component located on the backside of the component area. The display area includes a pixel defining layer defining an opening overlapping an anode; a cathode covering the pixel defining layer, a sealing layer located above the cathode, and a light blocking layer located above the sealing layer and having an opening overlapping the opening of the pixel defining layer, where the light blocking layer and the pixel defining layer each extend to the component area and define an additional opening therein corresponding to each optical sensor area of the plurality of optical sensor areas, and an area of the additional opening of the light blocking layer is smaller than an area of the additional opening of the pixel defining layer in a plan view such that a portion of the pixel defining layer in the optical sensor area is shielded by the light blocking layer in the plan view.

A portion of the cathode located on an inclined surface of the pixel defining layer in the each optical sensor area may be obscured by the light blocking layer in the plan view.

The gap between the additional opening of the pixel defining layer and the additional opening of the light blocking layer may be 1 µm to 2 µm, preferably equal to or more than 1,2 µm and equal to or less than 1,8 µm, equal to or more than 1, 4 µm and equal to or less than 1,6 µm . .

The display area may be located on the encapsulation layer and may further include a plurality of color filters located in the opening of the light blocking layer.

The color filter may not be located in the optical sensor area.

The component area may be divided into a plurality of component areas, and the component area located close to the display area may have a smaller density or size of the optical sensor area than the component area located relatively far from the display area.

The component area may have a 1-1 component area, a 1-2 component area, and a 1-3 component area, the 1-3 component area may be located closest to the display area, and the 1-1 component area may be located furthest from the display area, the density or size of the optical sensor area of the 1-1 component area may be the largest, and the density or size of the optical sensor area of the 1-2 component area may be an intermediate value, and the density or size of the optical sensor area of the 1-3 component area may have the smallest value of the 1-1 component area, the 1-2 component area, and the 1-3 component area.

A buffer area may be located between the component area and the display area.

According to embodiments, a plurality of first optical sensor areas OPS1 through which light can pass are located in the first component area EA1, and the first optical sensor area OPS1 is located in the first component area EA1 of the light blocking layer located at the top or an area of the opening of the color filter is smaller than an area of the opening of the black pixel defining layer located below in a plan view, so external light is not reflected from the cathode located above the black pixel defining layer, so the first optical sensor area OPS1 may not be visible.

According to embodiments, a plurality of first optical sensor areas OPS1 through which light can pass are located in the first component area EA1, and the density of the first optical sensor area OPS1 is adjusted so that the boundary with the display area DA is not easily visible.

According to embodiments, a buffer area is placed between the first component area EA1 and the display area DA so that the boundary between the display area DA and the first component area EA1 is not easily visible.

### BRIEF DESCRIPTION OF THE DRAWINGS

FIG. 1 is a schematic perspective view illustrating a use state of a display device according to an exemplary embodiment.
FIG. 2 is an exploded perspective view of a display device according to an embodiment.
FIG. 3 is a block diagram of a display device according to an embodiment.
FIG. 4 is a perspective view schematically showing a light emitting display device according to another embodiment.
FIG. 5 is an enlarged plan view of a partial area of a light emitting display device according to an embodiment.
FIG. 6 to FIG. 9 are diagrams specifically showing the structure of each layer according to the manufacturing sequence of a portion of the pixel circuit portion of the lower panel layer of the light emitting display device according to an embodiment.
FIG. 10 is a cross-sectional view of a display panel of a light emitting display device according to an embodiment.
FIG. 11 is a plan view of the first optical sensor area of the first component area according to one embodiment.
FIG. 12 is a cross-sectional view of the first optical sensor area of the first component area of FIG. 11.
FIG. 13 is a plan view of the first optical sensor area of the first component area according to a comparative example.
FIG. 14 is a cross-sectional view of the first optical sensor area of the first component area of FIG. 13.
FIG. 15A is a cross-sectional view of a display panel of a light emitting display device according to another embodiment.FIG. 15B to FIG. 19 are cross-sectional views of the first optical sensor area of the first component area according to other embodiments.
FIG. 20 is a graph showing the transmittance according to the wavelength of the color filter.
FIG. 21 is a plan view of the first optical sensor area of the first component area according to another embodiment.
FIG. 22 to FIG. 24 are schematic plan views of a first component area according to an embodiment.
FIG. 25 and FIG. 26 are plan views of the first component area according to an embodiment.
FIG. 27 is a plan view of a first component area according to another embodiment.
FIG. 28 is a table classifying the structure of the first component area according to an embodiment.
FIG. 29 is a schematic plan view of a first component area and its surrounding area according to another embodiment.
FIG. 30 is a schematic cross-sectional view of the first component area of FIG. 29 and its surrounding area.
FIG. 31 and FIG. 32 are photographs of the first component area according to an embodiment.
FIG. 33 is a cross-sectional view of a display panel of a light emitting display device according to another embodiment.
FIG. 34 is a cross-sectional view of a display panel of a light emitting display device according to still another embodiment.

### DETAILED DESCRIPTION

Hereinafter, with reference to the attached drawings, various embodiments will be described in detail so that those skilled in the art can easily implement the present invention.

The invention may be implemented in many different forms and is not limited to the embodiments described herein.

In order to clearly explain the present invention, parts that are not relevant to the description are omitted, and identical or similar components are assigned the same reference numerals throughout the specification.

In addition, the size and thickness of each component shown in the drawings are arbitrarily shown for convenience of explanation, so the present invention is not necessarily limited to what is shown.

In the drawing, the thickness is enlarged to clearly express various layers and areas.

And in the drawings, for convenience of explanation, the thicknesses of some layers and regions are exaggerated.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items.

Additionally, when a part, such as a layer, membrane, region, plate or component is said to be "above" or "on" another part, this means not only when it is "directly above" another part, but also when there is another part in between.

In contrast, when an element is referred to as being "directly on" another element, there are no intervening elements present.

In addition, being "above" or "on" a reference part means being located above or below the reference part, and does not necessarily mean being located "above" or "on" it in the direction opposite to gravity.

In addition, throughout the specification, when a part is said to "include" a certain component, this means that it may further include other components rather than excluding other components, unless specifically stated to the contrary.

In addition, throughout the specification, when reference is made to "in a plan view," this means when the target portion is viewed from above (viewed in a third direction DR3), and when reference is made to "in cross-section," this means when a cross-section of the target portion is cut vertically and viewed from the side.

In addition, throughout the specification, when "connected" is used, this does not mean only when two or more components are directly connected, but it also means that when two or more components are indirectly connected through other components, they are physically connected. This may include not only the case of being connected or electrically connected, but also the case where each part, which is referred to by different names depending on location or function, is substantially connected to each other.

In addition, throughout the specification, when a portion such as a wiring, layer, layer, region, plate, or component is said to "extend in the first or second direction," this means only a straight shape extending in that direction, but also a structure that extends overall along the first or second direction, and also a structure that is bent at some part, has a zigzag structure, or extends with a curved structure.

In addition, electronic devices (e.g., mobile phones, TVs, monitors, laptop computers, etc.) containing display devices, display panels, etc. described in the specification, or display devices, display panels, etc. manufactured by the manufacturing method described in the specification are not excluded from the scope of the rights herein.

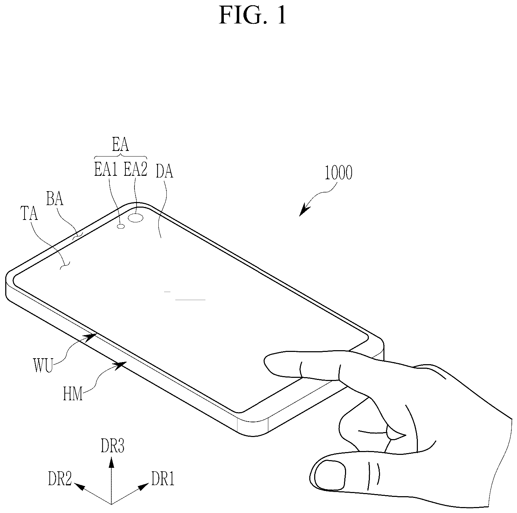

Below, the schematic structure of the display device through FIG. 1 to FIG. 3 will be explained.

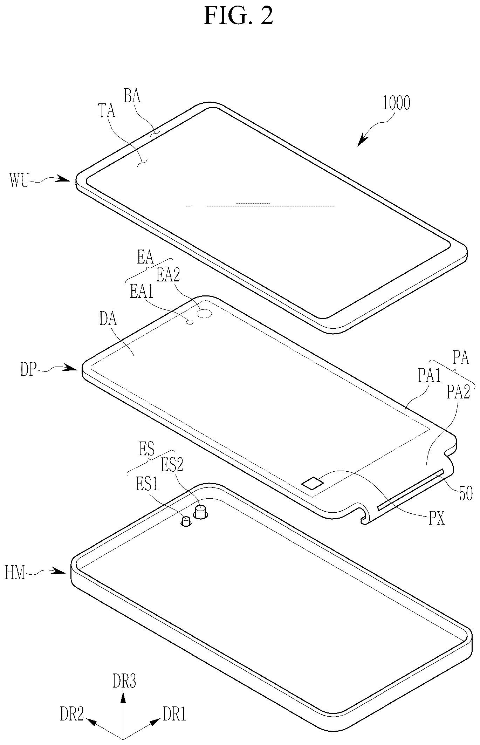

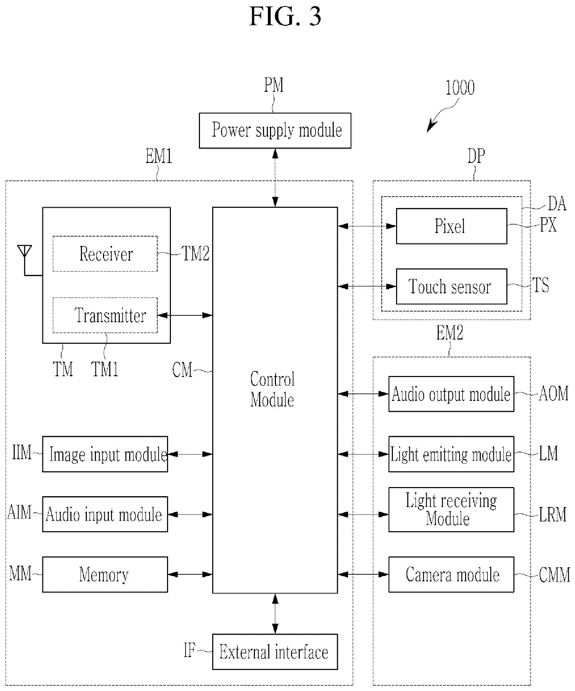

FIG. 1 is a schematic perspective view showing a use state of a display device according to an embodiment, FIG. 2 is an exploded perspective view of a display device according to an embodiment, and FIG. 3 is a block diagram of a display device according to an embodiment.

Referring to FIG. 1, a light emitting display device 1000 according to an embodiment is a device that displays moving images or still images, and can be used in mobile phones, smart phones, tablet personal computers, portable electronic devices such as mobile communication terminals, electronic notebooks, e-books, portable multimedia players (PMP), navigation, and ultra mobile (UMPC), as well as televisions, laptops, monitors, billboards, and the internet of things (IOT).

Also, the display device 1000 according to an embodiment can be used in wearable devices such as smart watches, watch phones, glasses-type displays, and head-mounted displays (HMD).

In addition, the display device 1000 according to one embodiment includes a dashboard of a car, a center information display CID placed on the center fascia or dashboard of a car, and a room mirror display instead of a side mirror of a car can be used as entertainment for the back seat of a car, and as a display placed on the back of a front seat.

FIG. 1 shows the display device 1000 being used as a smart phone, for convenience of explanation.

The display device 1000 may display an image in a third direction DR3 on a display surface parallel to each of a first direction DR1 and a second direction DR2.

The display surface on which the image is displayed may correspond to the front surface of the display device 1000 and the front surface of the cover window WU.

Images may include static images as well as dynamic images.

In this embodiment, the front (or top) and back (or bottom) surfaces of each member are defined based on the direction in which the image is displayed.

The front and back surfaces are opposed to each other in the third direction DR3, and the normal directions of each of the front and back surfaces may be parallel to the third direction DR3.

The separation distance between the front and back surfaces in the third direction DR3 may correspond to the thickness of the display panel in the third direction DR3. That is, the third direction DR3 is a thickness direction of a substrate 110.

The display device 1000 according to one embodiment may detect a user's input (refer to the hand in FIG. 1) applied from the outside.

The user's input may include various types of external inputs, such as parts of the user's body, light, heat, or pressure.

In one embodiment, the user's input is shown with the user's hand applied to the front.

However, the present invention is not limited to this.

The user's input may be provided in various forms, and the display device 1000 may also detect the user's input applied to the side or back of the display device 1000 depending on the structure of the display device 1000.

Referring to FIG. 1 and FIG. 2, the display device 1000 may include a cover window WU, a housing HM, a display panel DP, and an optical element ES.

In one embodiment, the cover window WU and the housing HM may be combined to configure the exterior of the display device 1000.

The cover window WU may include an insulating panel.

For example, the cover window WU may be made of glass, plastic, or a combination thereof.

The front of the cover window WU may define the front of the display device 1000.

A transmission area TA may be an optically transparent area.

For example, the transmission area TA may be an area with a visible light transmittance of about 90% or more.

A blocking area BA may define the shape of the transmission area TA.

The blocking area BA is adjacent to the transmission area TA and may surround the transmission area TA.

The blocking area BA may be an area with relatively low light transmittance compared to the transmission area TA.

The blocking area BA may include an opaque material that blocks light.

The blocking area BA may have a predetermined color.

The blocking area BA may be defined by a bezel layer provided separately from a transparent substrate defining the transmission area TA, or may be defined by an ink layer formed by inserting or coloring the transparent substrate.

A display panel DP may include a display panel DP that displays an image and a driver 50.

The display panel DP may include a front surface including a display area DA and a non-display area PA.

The display area DA may be an area where pixels operate according to electrical signals and emit light.

In one embodiment, the display area DA is an area where an image is displayed including a pixel, and at the same time, it may be an area where an external input is sensed by having a touch sensor located above the pixel in the third direction DR3.

The transmission area TA of the cover window WU may at least partially overlap the display area DA of the display panel DP.

For example, the transmission area TA may overlap the entire surface of the display area DA or may overlap at least a portion of the display area DA.

Accordingly, the user can view the image through the transmission area TA or provide external input based on the image.

However, the present invention is not limited to this.

For example, within the display area DA, an area where an image is displayed and an area where an external input is detected may be separated from each other.

A non-display area PA of the display panel DP may at least partially overlap the blocking area BA of the cover window WU.

The non-display area PA may be an area covered by the blocking area BA.

The non-display area PA is adjacent to the display area DA and may surround the display area DA.

An image is not displayed in the non-display area PA, and a driving circuit or driving wiring may be disposed to drive the display area DA.

The non-display area PA may include a first peripheral area PA1 located outside the display area DA and a second peripheral area PA2 including the driver 50, connection wiring, and a bending area.

In the embodiment of FIG. 2, the first peripheral area PA1 is located on the third side of the display area DA, and the second peripheral area PA2 is located on the remaining side of the display area DA.

In one embodiment, the display panel DP may be assembled in a flat state with the display area DA and the non-display area PA facing the cover window WU.

However, the present invention is not limited to this.

A portion of the non-display area PA of the display panel DP may be curved.

At this time, part of the non-display area PA is directed toward the rear of the display device 1000, so that the blocking area BA visible on the front of the display device 1000 can be reduced, and in FIG. 2, the second peripheral area PA2 can be bent and placed on the back of the display area DA and then assembled.

Additionally, the display panel DP may include a component area EA, and specifically, a first component area EA1 and a second component area EA2. The component area is an area where components that use infrared light, visible light, or sound are placed below them.

The first component area EA1 and the second component area EA2 may be at least partially surrounded by the display area DA.

The first component area EA1 and the second component area EA2 are shown spaced apart from each other, but are not limited to this and may be at least partially connected.

The first component area EA1 and the second component area EA2 may be areas where components that use infrared light, visible light, or sound are placed below them.

The display area DA is formed with a plurality of light emitting diodes and a plurality of pixel circuit units that generate and transmit light emitting current to each of the plurality of light emitting diodes.

Here, one light emitting diode and one pixel circuit part are called a pixel PX.

In the display area DA, one pixel circuit unit and one light emitting diode are formed in a one-to-one arrangement.

The first component area EA1 includes an area composed of a transparent layer so that light can pass therethrough, and no conductive layer or semiconductor layer is located thereon, and a pixel defining layer containing a light blocking material, a light blocking layer, etc. are included in the first component area, and by including an opening that overlaps the position corresponding to the first component area EA1, it is possible to have a structure that does not block light.

The second component area EA2 may include a transparent portion through which light and/or sound can pass and a display portion including a plurality of pixels.

The transmitting portion is located between adjacent pixels and is composed of a transparent layer through which light and/or sound can pass.

The display unit can be formed to have a single unit structure by combining a plurality of pixels, and a transparent part can be located between adjacent unit structures.

Referring to FIG. 1 to FIG. 3, the display panel DP may include a display area DA including display pixels and a touch sensor TS.

The display panel DP includes pixels that generate images and can be visible to the user from the outside through the transmission area TA.

Additionally, the touch sensor TS may be located at the top of the pixel and may detect an external input applied from the outside.

The touch sensor TS can detect an external input provided to the cover window WU.

Referring again to FIG. 2, the second peripheral area PA2 may include a bending portion.

The display area DA and the first peripheral area PA1 may have a flat state substantially parallel to the plane defined by the first direction DR1 and the second direction DR2, and one side of the second peripheral area PA2 may be extended from a flat state, pass through a bending portion, and then be in a flat state again.

As a result, at least a portion of the second peripheral area PA2 may be bent and assembled to be located on the rear side of the display area DA.

When at least a portion of the second peripheral area PA2 is assembled, it overlaps the display area DA in a plan view, so the blocking area BA of the display device 1000 may be reduced.

However, the present invention is not limited to this.

For example, the second peripheral area PA2 may not be bent.

The driver 50 may be mounted on the second peripheral area PA2, on the bending part, or on one or opposite sides of the bending part.

The driver 50 may be provided in the form of a chip.

The driver 50 is electrically connected to the display area DA and can transmit an electrical signal to the display area DA.

For example, the driver 50 may provide data signals to the pixels PX arranged in the display area DA.

Alternatively, the driver 50 may include a touch driving circuit and may be electrically connected to the touch sensor TS disposed in the display area DA.

Meanwhile, the driver 50 may include various circuits in addition to the above-described circuits or may be designed to provide various electrical signals to the display area DA.

Meanwhile, the display device 1000 may have a pad portion located at an end of the second peripheral area PA2, and is electrically connected to a flexible printed circuit board FPCB including a driving chip by the pad portion.

Here, the driving chip located on the flexible printed circuit board may include various driving circuits for driving the display device 1000 or a connector for power supply.

Depending on the embodiment, a rigid printed circuit board (PCB) may be used instead of a flexible printed circuit board.

The optical element ES may be disposed below the display panel DP.

The optical element ES may include a first optical element ES1 overlapping the first component area EA1 and a second optical element ES2 overlapping the second component area EA2.

The first optical element ES1 may be an electronic element that uses light or sound.

For example, the first optical element ES1 is a sensor that receives and uses light such as an infrared sensor, a sensor that outputs and detects light or sound to measure distance or recognize a fingerprint, etc., or a small lamp that outputs light, or it may be a speaker that outputs sound, etc.

Of course, in the case of electronic elements that use light, light of various wavelength bands, such as visible light, infrared light, and ultraviolet light, can be used.

The second optical element ES2 may be at least one of a camera, an IR camera, a dot projector, an IR illuminator, and a time-of-flight sensor.

Referring to FIG. 3, the display device 1000 may include a display panel DP, a power supply module PM, a first electronic module EM1, and a second electronic module EM2.

The display panel DP, the power supply module PM, the first electronic module EM1, and the second electronic module EM2 may be electrically connected to each other.

FIG. 3 illustrates display pixels and a touch sensor TS located in the display area DA among the configuration of the display panel DP.

The power supply module PM can supply power required for the overall operation of the display device 1000.

The power supply module PM may include a conventional battery module.

The first electronic module EM1 and the second electronic module EM2 may include various functional modules for operating the display device 1000.

The first electronic module EM1 may be mounted directly on the motherboard electrically connected to the display panel DP, or it may be mounted on a separate board and electrically connected to the motherboard through a connector (not shown).

The first electronic module EM1 may include a control module CM, a wireless communication module TM, an image input module IIM, an audio input module AIM, a memory MM, and an external interface IF.

Some of the modules may not be mounted on the motherboard, but they may be electrically connected to the motherboard through a flexible printed circuit board connected thereto.

The control module CM may control the overall operation of the display device 1000. The control module CM may be a microprocessor.

For example, the control module CM activates or deactivates the display panel DP.

The control module CM can control other modules, such as an image input module IIM or an audio input module AIM, based on the touch signal received from the display panel DP.

The wireless communication module TM can transmit/receive wireless signals to and from other terminals using a Bluetooth or Wi-Fi line.

The wireless communication module TM can transmit/receive voice signals using a general communication line.

The wireless communication module TM includes a transmitter TM1 that modulates and transmits a signal to be transmitted, and a receiver TM2 that demodulates the received signal.

The image input module IIM can process video signals and convert them into video data that can be displayed on the display panel DP.

The audio input module AIM can receive external acoustic signals through a microphone in recording mode, voice recognition mode, etc. and convert them into electrical voice data.

The external interface IF may serve as an interface connected to an external charger, wired/wireless data port, card socket (e.g., memory card, SIM/UIM card), etc.

The second electronic module EM2 may include an audio output module AOM, a light emitting module LM, a light receiving module LRM, and a camera module CMM, at least some of which include optical elements ES, and it may be located on the back of the display panel DP, as shown in FIG. 1 and FIG. 2.

The optical element ES may include the light emitting module LM, the light receiving module LRM, and the camera module CMM.

In addition, the second electronic module EM2 is mounted directly on the motherboard, is mounted on a separate board and is electrically connected to the display panel DP through a connector (not shown), or is connected to the first electronic module EM 1.

The audio output module AOM can convert audio data received from the wireless communication module TM or audio data stored in the memory MM and output it to the outside.

The light emitting module LM can generate and output light.

The light emitting module LM can output infrared rays.

For example, the light emitting module LM may include an LED device.

For example, a light receiving module LRM can detect infrared light.

The light receiving module LRM may be activated when infrared rays above a certain level are detected.

The light receiving module LRM may include a CMOS sensor.

After the infrared light generated in the light emitting module LM is output, it is reflected by an external subject (e.g., a user's finger or face), and the reflected infrared light may be incident on the light receiving module LRM.

The camera module CMM can capture external images.

In one embodiment, the optical element ES may additionally include a light-detection sensor or a heat-detection sensor.

The optical element ES can detect an external subject received through the front or provide a sound signal such as a voice to the outside through the front.

Additionally, the optical element ES may include a plurality of components and is not limited to any one embodiment.

Again, referring to FIG. 2, the housing HM may be combined with the cover window WU.

The cover window WU may be disposed on the front of the housing HM.

The housing HM can be combined with the cover window WU to provide a predetermined accommodation space.

The display panel DP and the optical element ES may be accommodated in a predetermined accommodation space provided between the housing HM and the cover window WU.

The housing HM may include a material with relatively high rigidity.

For example, the housing HM may include a plurality of frames and/or plates made of glass, plastic, or metal, or a combination thereof.

The housing HM can stably protect the components of the display device 1000 accommodated in the internal space from external shock.

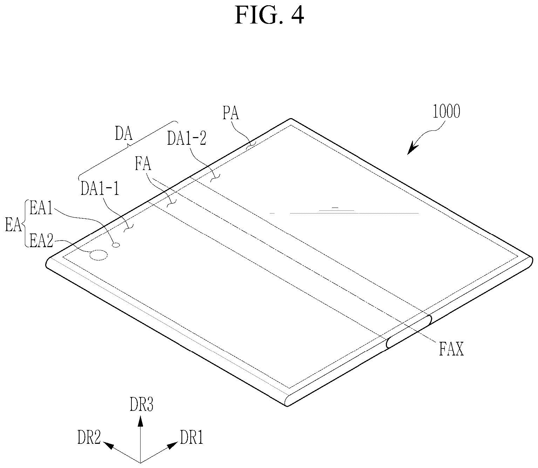

Hereinafter, the structure of the display device 1000 according to another embodiment will be looked at through FIG. 4.

FIG. 4 is a perspective view schematically showing a display device according to another embodiment.

Description of the same components as the above-described components will be omitted.

The embodiment of FIG. 4 shows a foldable display device in which the display device 1000 is folded through a folding axis FAX.

Referring to FIG. 4, in one embodiment, the display device 1000 may be a foldable display device.

The display device 1000 may be folded outward or inward based on the folding axis FAX.

When folded outward based on the folding axis FAX, the display surfaces of the display device 1000 are positioned on the outside in the third direction DR3 so that images can be displayed in both directions.

If it is folded inward based on the folding axis FAX, the display surface may not be visible from the outside.

In one embodiment, the display device 1000 may include the display area DA, the component area EA, and the non-display area PA.

The display area DA may be divided into a 1-1 display area DA1-1, a 1-2 display area DA1-2, and a folding area FA.

The 1-1 display area DA1-1 and the 1-2 display area DA1-2 may be located on the left and right sides, respectively, based on (or centered on) the folding axis FAX, and the first the folding area FA may be located between the 1-1 display area DA1-1 and the 1-2 display area DA1-2.

At this time, when folded outward based on the folding axis FAX, the 1-1 display area DA1-1 and the 1-2 display area DA1-2 are located on opposite sides in the third direction DR3, which allows images to be displayed in both directions.

Additionally, when folded inward based on the folding axis FAX, the 1-1 display area DA1-1 and the 1-2 display area DA1-2 may not be visible from the outside.

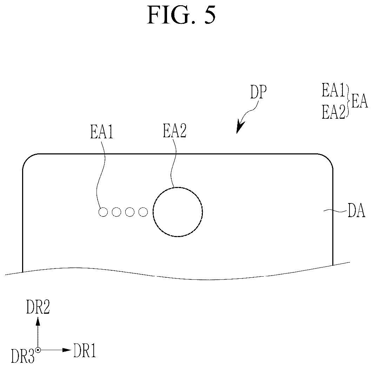

FIG. 5 is an enlarged plan view of a partial area of a light emitting display device according to an embodiment.

FIG. 5 shows a portion of a light emitting display panel DP of a light emitting display device according to an embodiment, and is shown using a display panel for a mobile phone.

The light emitting display panel DP has a display area DA located on the front, and may include a component area EA on the front, specifically including a first component area EA1 and a second component area EA2.

Additionally, in the embodiment of FIG. 5, the first component area EA1 is located adjacent to the second component area EA2.

In the embodiment of FIG. 5, the first component area EA1 is located to the left of the second component area EA2.

The location and number of the first component areas EA1 may vary depending on the embodiment.

In FIG. 5, the optical element corresponding to the second component area EA2 may be a camera, and the optical element corresponding to the first component area EA1 may be an optical sensor.

The display area DA is formed with a plurality of light emitting diodes and a plurality of pixel circuit units that generate and transmit light emitting current to each of the plurality of light emitting diodes.

Here, one light emitting diode and one pixel circuit part are called a pixel PX.

In the display area DA, one pixel circuit part and one light emitting diode are formed in a one-to-one arrangement.

The display area DA is hereinafter also referred to as the "normal display area."

Although the structure of the light emitting display panel DP below the cutting line is not shown in FIG. 5, the display area DA may be located below the cutting line.

The first component area EA1 includes a transparent layer so that light can pass therethrough, the transparent layer has no conductive layer or semiconductor layer, has an auxiliary optical sensor area OPS in the lower panel layer, and has an optical sensor area OPS in the upper panel layer, and a light blocking layer 220 and the color filter 230 may have a structure that does not block light by forming an opening (hereinafter referred to as an additional opening) at a position corresponding to the secondary optical sensor area OPS.

Additionally, a black pixel defining layer 380 located above the secondary optical sensor area OPS in the lower panel layer may have an additional opening corresponding to the secondary optical sensor area OPS.

A plurality of adjacent optical sensor areas OPS may form one first component area EA1.

Even if the secondary optical sensor area OPS is located in the lower panel layer, there may not be an opening corresponding to the upper panel layer or the black pixel defining layer 380.

That is, an opening is formed in the black pixel defining layer 380 and the light blocking layer 220 located on a portion of the secondary optical sensor area OPS located in the first component area EA1, and a black pixel definition is formed on the remaining portion, and it may be blocked with the black pixel defining layer 380 and/or the light blocking layer 220.

A portion of the optical sensor area OPS in the first component area EA1 allows light to pass therethrough, so even if the sensor is formed on the back of the light emitting display device, the front surface can be detected.

In contrast, the secondary optical sensor area OPS is located in the display area, but all secondary optical sensor areas OPS are blocked by the black pixel defining layer 380 and/or the light blocking layer 220, so that light cannot pass therethrough, so the area may not exist, and a sensor cannot be located behind them.

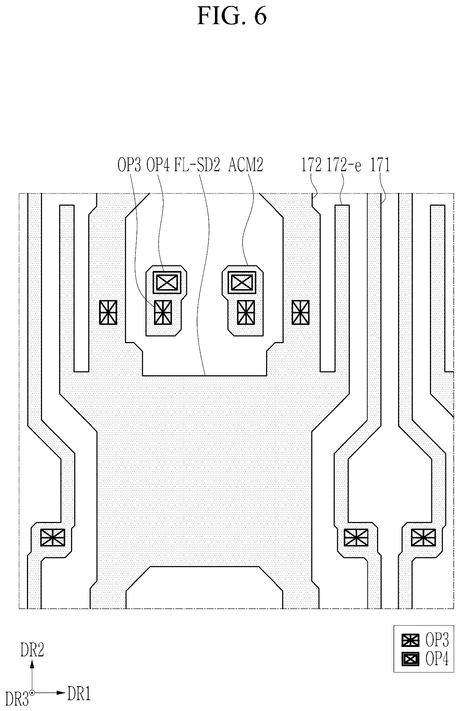

FIG. 6 to FIG. 9, which will be described later, show one pixel and one secondary optical sensor area OPS, and may have a pixel structure of the first component area EA1 or the display area DA.

Meanwhile, depending on the embodiment, the pixels of FIG. 6 to FIG. 9 may also be formed in the second component area EA2.

The light emitting display panel DP according to the embodiment can be largely divided into a lower panel layer and an upper panel layer.

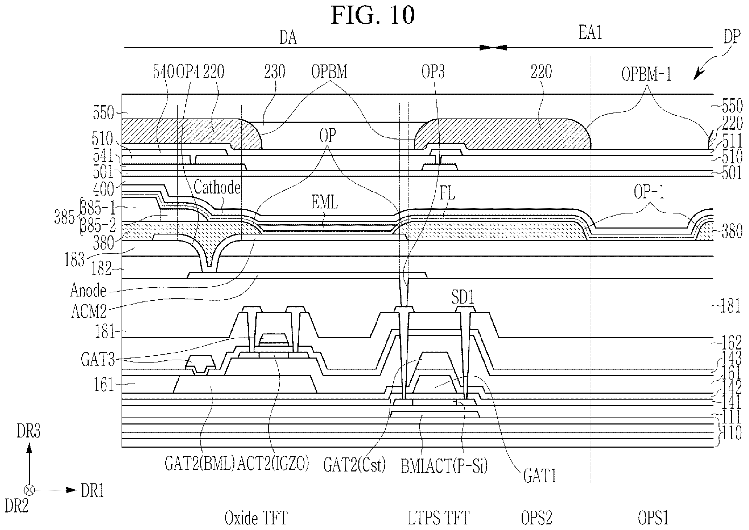

The lower panel layer is the part where the light emitting diode and the pixel circuit part that constitute the pixel are located, and may even include an encapsulation layer (see 400 in FIG. 10) covering it.

That is, the lower panel layer is from the substrate (see 110 in FIG. 10) to the encapsulation layer (see 400 in FIG. 10) and includes an anode (see Anode in FIG. 10), a black pixel defining layer (see 380 in FIG. 10), a light emitting layer (see EML in FIG. 10), and a spacer (see 385 in FIG. 10), a functional layer (see FL in FIG. 10), and a cathode (see Cathode in FIG. 10), and also includes an insulating layer between the substrate and the anode, a semiconductor layer, and a conductive layer.

Meanwhile, the upper panel layer is located above the encapsulation layer and includes a sensing insulating layer capable of detecting touch (see 501, 510, and 511 in FIG. 10) and a plurality of sensing electrodes (see 540 and 541 in FIG. 10) and may include a light blocking layer (see 220 in FIG. 10), a color filter (see 230 in FIG. 10), and a planarization layer (see 550 in FIG. 10).

Meanwhile, the structure of the lower panel layer of the display area DA will be explained focusing on FIG. 6 to FIG. 10.

Although not shown in FIG. 5, a peripheral area may be further located outside the display area DA.

In addition, although FIG. 5 shows a display panel for a mobile phone, this embodiment can be applied to any display panel in which optical elements can be located on the back of the display panel, and it can also be a flexible display device.

In the case of a foldable display device among flexible display devices, the second component area EA2 and the first component area EA1 may be formed in positions different from those shown in FIG. 5.

The circuit structure of the pixel located in the lower panel layer of the light emitting display panel DP may vary and may include a driving transistor that outputs current to the light emitting element, at least one switching transistor, and at least one capacitor and pixels with various circuit structures can be used.

Hereinafter, the detailed planar structure and stacked structure of the pixels formed in the display area DA will be looked at through FIG. 6 to FIG. 10, and each pixel in the following embodiment includes one secondary optical sensor area OPS.

FIG. 6 to FIG. 9 are diagrams specifically showing the structure of each layer according to the manufacturing sequence of a portion of the pixel circuit portion of the lower panel layer of the light emitting display device according to an embodiment.

FIG. 6 shows the structure of the second data conductive layer in the pixel circuit unit.

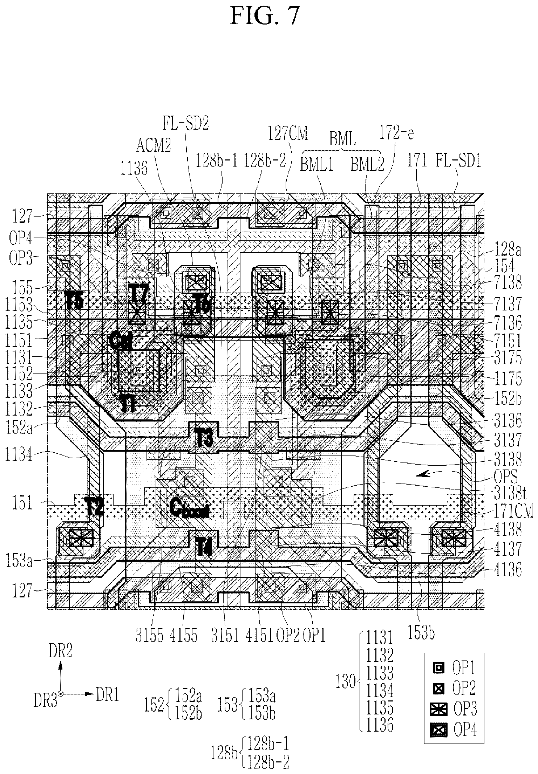

A plurality of gate conductive layers, a semiconductor layer, and a first data conductive layer may be located below the second data conductive layer, and the detailed structure is shown in FIG. 7.

Referring to FIG. 6, the first organic layer (see 181 in FIG. 10) located below the second data conductive layer has a lower organic layer opening OP3.

The lower organic layer opening OP3 may overlap and expose a connection part 171CM, an anode connection electrode ACM1, and an expansion part FL-SD1 located in the first data conductive layer in a plan view.

A second data conductive layer including a data line 171, a driving voltage line 172, and an anode connection electrode ACM2 may be positioned on the first organic layer 181.

A second organic layer 182 and a third organic layer 183 are located on the second data conductive layer, and an anode connection opening OP4 is located on the second organic layer 182 and the third organic layer 183.

The anode connection electrode ACM2 may be electrically connected to the anode through the anode connection opening OP4.

In FIG. 6, the data line 171 and the driving voltage line 172 may extend approximately in the vertical direction (e.g., second direction DR2).

The data line 171 may be connected to the connection part 171CM of the first data conductive layer through the lower organic layer opening OP3.

The data line 171 extends in the vertical direction and has a structure in which it is bent, and the data line 171 at the bent portion may form the boundary of the secondary optical sensor area OPS.

A plurality of adjacent optical sensor areas OPS may form one first component area EA1.

The driving voltage line 172 may be connected to the expansion part FL-SD1 of the first data conductive layer through the lower organic layer opening OP3.

The anode connection electrode ACM2 may be electrically connected to the anode connection electrode ACM1 of the first data conductive layer through the opening OP3.

Referring to FIG. 6, the driving voltage line 172 further includes an expansion part FL-SD2 and a protruding wiring portion 172-e, and has a structure that is not formed in the portion where the anode connection electrode ACM2 is formed.

The expansion part FL-SD2 is formed widely to flatten the anode located at the top.

Meanwhile, two protruding wiring portions 172-e of the driving voltage line 172 are formed on opposite sides of the two data lines 171 to flatten the anode located above them, resulting in a total of four wiring structures 171, 172-e located at the bottom of the anode.

Referring to FIG. 7, two data lines 171 formed adjacent to each other are bent in opposite directions and have a portion with a large gap, and this portion corresponds to the secondary optical sensor area OPS.

One secondary optical sensor area OPS is located between two adjacent pixel circuit units.

The left and right boundaries of the secondary optical sensor area OPS are composed of two data lines 171, and the lower border is formed by a first scan line 151, and a lower second scan line 152a and/or a second scan line 152a. The upper boundary can be formed by a scan line 152b.

Depending on the embodiment, a portion 1134 of a first semiconductor layer 130 that overlaps the data line 171 in a plan view may form the left and right boundaries of the secondary optical sensor area OPS.

The anode has flattening characteristics due to the structure of the lower part of the anode as described above.

The second data conductive layer SD2 may include a metal or metal alloy such as aluminum (Al), copper (Cu), molybdenum (Mo), or titanium (Ti), and may be composed of a single layer or multiple layers.

In FIG. 7, layers other than the second data conductive layer of FIG. 6 are also shown. A schematic examination of the structure of the pixel circuit portion of the overall lower panel layer through FIG. 7 and FIG. 10 is as follows.

Referring to FIG. 7 and FIG. 10, a metal layer BML is located on the substrate 110.

The substrate 110 may include a material that has rigid properties and does not bend, such as glass, or may include a flexible material that can bend, such as plastic or polyimide.

In the case of a flexible substrate, as shown in FIG. 10, it may have a double-layer structure of polyimide and a barrier layer formed of an inorganic insulating material thereon.

The metal layer BML includes a plurality of expansion parts BML1 and a connection part BML2 connecting the plurality of expansion parts BML1 to each other.

The expansion part BML1 of the metal layer BML may be formed at a position that overlaps the channel 1132 of a driving transistor T1 in the following first semiconductor layer in a plan view.

The metal layer BML is also called the lower shielding layer and may include metal or metal alloy such as copper (Cu), molybdenum (Mo), aluminum (Al), and titanium (Ti), may additionally include amorphous silicon and may be composed of a single layer or multiple layers.

Referring to FIG. 10, a buffer layer 111 covering the substrate 110 and the metal layer BML is located on top of the substrate 110.

The buffer layer 111 serves to block impure elements from penetrating into the first semiconductor layer 130, and may be an inorganic insulating layer containing silicon oxide (SiOx), silicon nitride (SiNx), or silicon oxynitride (SiONx).

The first semiconductor layer 130 formed of a silicon semiconductor (e.g., a polycrystalline semiconductor) is located on the buffer layer 111.

The first semiconductor layer 130 includes a channel 1132, a first region 1131, and a second region 1133 of the driving transistor T1.

In addition, the first semiconductor layer 130 includes channels for not only the driving transistor T1 but also a second transistor T2, the fifth transistor T5, and the sixth transistor T6, and plasma is formed on opposite sides of each channel. By processing or doping, it has a region with conductive layer properties and serves as a first electrode and a second electrode.

The transistor including the first semiconductor layer 130 may be referred to as a polycrystalline semiconductor transistor.

The channel 1132 of the driving transistor T1 may be bent in a U shape in a plan view.

However, the shape of the channel 1132 of the driving transistor T1 is not limited to this and may change in various ways.

For example, the channel 1132 of the driving transistor T1 may be bent into a different shape or may be shaped like a bar.

The first region 1131 and the second region 1133 of the driving transistor T1 may be located on opposite sides of the channel 1132 of the driving transistor T1.

The first region 1131 and the second region 1133 located in the first semiconductor layer serve as the first and second electrodes of the driving transistor T1.

The channel, the first region, and the second region of the second transistor T2 are located in the portion 1134 of the first semiconductor layer 130 extending downward from the first region 1131 of the driving transistor T1.

The channel, the first region, and the second region of a fifth transistor T5 are located in the portion 1135 extending upward from the first region 1131 of the driving transistor T1.

The channel, first region, and second region of a sixth transistor T6 are located in the portion 1136 extending upward from the second region 1133 of the driving transistor T1.

Referring to FIG. 10, the first gate insulating layer 141 is located on the first semiconductor layer 130 including the channel 1132, the first region 1131, and the second region 1133 of the driving transistor T1.

The first gate insulating layer 141 may be an inorganic insulating layer containing silicon oxide (SiOx), silicon nitride (SiNx), or silicon oxynitride (SiONx).

A first gate conductive layer including the gate electrode 1151 of the driving the transistor T1 may be positioned on the first gate insulating layer 141.

The first gate conductive layer includes gate electrodes of each of the driving transistor T1, as well as the second transistor T2, the fifth transistor T5, and the sixth transistor T6.

The gate electrode 1151 of the driving transistor T1 may overlap the channel 1132 of the driving transistor T1 in a plan view.

The channel 1132 of the driving transistor T1 is covered by the gate electrode 1151 of the driving transistor T1.

The first gate conductive layer may further include a first scan line 151 and an emission control line 155.

The first scan line 151 and an emission control line 155 may extend approximately in the horizontal direction (hereinafter also referred to as the first direction).

The first scan line 151 may be connected to the gate electrode of the second transistor T2.

The first scan line 151 may be integrated with the gate electrode of the second transistor T2.

Meanwhile, the emission control line 155 may be connected to the gate electrode of the fifth transistor T5 and the gate electrode of the sixth transistor T6, and the emission control line 155 and the fifth transistor T5 and the sixth transistor T6 may be connected to the gate electrodes of the fifth transistor T5 and the sixth transistor T6, and the gate electrode of T6 may be formed integrally.

The first gate conductive layer may include a metal or metal alloy such as copper (Cu), molybdenum (Mo), aluminum (Al), or titanium (Ti), and may be composed of a single layer or multiple layers.

After forming the first gate conductive layer including the gate electrode 1151 of the driving transistor T1, a plasma treatment or doping process may be performed to make the exposed area of the first semiconductor layer conductive.

That is, the first semiconductor layer covered by the first gate conductive layer is not conductive, and the portion of the first semiconductor layer not covered by the first gate conductive layer may have the same characteristics as the conductive layer.

As a result, the transistor including the conductive part has p-type transistor characteristics, and the driving transistor T1, the second transistor T2, the fifth transistor T5, and the sixth transistor T6 are p-type transistors.

Referring to FIG. 10, the second gate insulating layer 142 may be positioned on the first gate conductive layer and the first gate insulating layer 141 may include the gate electrode 1151 of the driving transistor T1.

The second gate insulating layer 142 may be an inorganic insulating layer containing silicon oxide (SiOx), silicon nitride (SiNx), or silicon oxynitride (SiONx).

A first storage electrode 1153 of a storage capacitor Cst, a lower shielding layer 3155 of the third transistor T3, and a lower shielding layer 4155 of a fourth transistor T4 are placed on the second gate insulating layer 142.

The lower shielding layers 3155 and 4155 are located below the channels of the third and fourth transistors T3 and T4, respectively, and serve to shield from light or electromagnetic interference provided to the channel from below.

The first storage electrode 1153 overlaps the gate electrode 1151 of the driving transistor T1 to form the storage capacitor Cst in a plan view.

An opening 1152 is formed in the first storage electrode 1153 of the storage capacitor Cst.

The opening 1152 of the first storage electrode 1153 of the storage capacitor Cst may overlap the gate electrode 1151 of the driving transistor T1 in a plan view.

The first storage electrode 1153 extends in the horizontal direction (e.g., first direction DR1) and is connected to the adjacent first storage electrode 1153.

The lower shielding layer 3155 of the third transistor T3 may overlap a channel 3137 and the gate electrode 3151 of the third transistor T3 in a plan view.

The lower shielding layer 4155 of the fourth transistor T4 may overlap the channel 4137 and the gate electrode 4151 of the fourth transistor T4 in a plan view.

The second gate conductive layer may further include a lower second scan line 152a, a lower initialization control line 153a, and a first initialization voltage line 127.

The lower second scan line 152a, the lower initialization control line 153a, and the first initialization voltage line 127 may extend approximately in the horizontal direction (e.g., first direction DR1).

The lower second scan line 152a may be connected to the lower shielding layer 3155 of the third transistor T3.

The lower second scan line 152a may be connected to the lower shielding layer 3155 of the third transistor T3.

The lower initialization control line 153a may be connected to the lower shielding layer 4155 of the fourth transistor T4.

The lower initialization control line 153a may be connected to the lower shielding layer 4155 of the fourth transistor T4.

A second gate conductive layer GAT2 may include a metal or metal alloy such as copper (Cu), molybdenum (Mo), aluminum (Al), or titanium (Ti), and may be composed of a single layer or multiple layers.

Referring to FIG. 10, a first interlayer-insulating layer 161 may be positioned on the second gate conductive layer including the first storage electrode 1153 of the storage capacitor Cst, the lower shielding layer 3155 of the third transistor T3, and the lower shielding layer 4155 of the fourth transistor T4.

The first interlayer-insulating layer 161 may include an inorganic insulating layer containing silicon oxide (SiOx), silicon nitride (SiNx), or silicon oxynitride (SiONx). Depending on the embodiment, the inorganic insulating material may be formed thickly.

On the first interlayer-insulating layer 161, an oxide semiconductor layer including the channel 3137, first region 3136, and second region 3138 of the third transistor T3, the channel 4137, the first region 4136 and the second region 4138 of the fourth transistor T4, and , and the channel 7137, the first region 7136, and the second region 7138 of the seventh transistor T7 may be located.

Additionally, the oxide semiconductor layer may further include an upper boost electrode 3138t of the boost capacitor C_{boost}.

The channel 3137, first region 3136, and second region 3138 of the third transistor T3, channel 4137, first region 4136, and second region 4138 of the fourth transistor T4 can be connected to each other and formed as a whole.

Meanwhile, the channel 7137, first region 7136, and second region 7138 of the seventh transistor T7 are similar to the channel 3137 of the third transistor T3 and the channel 4137 of the fourth transistor T4, so the oxide semiconductor layer can be divided into two separate parts.

The first region 3136 and the second region 3138 of the third transistor T3 are located on opposite sides of the channel 3137 of the third transistor T3, and the first region 4136 and the second region 4138 of the fourth transistor T4 is located on opposite sides of the channel 4137 of the fourth transistor T4,.

The second region 3138 of the third transistor T3 is connected to the second region 4138 of the fourth transistor T4.

The channel 3137 of the third transistor T3 overlaps the lower shielding layer 3155, and the channel 4137 of the fourth transistor T4 overlaps the lower shielding layer 4155 in a plan view.

The first region 7136 and the second region 7138 of the seventh transistor T7 are located on opposite sides of the channel 7137 of the seventh transistor T7.

A transistor including an oxide semiconductor layer can be referred to as an oxide semiconductor transistor.

The upper boost electrode 3138t of the boost capacitor Cboost is located between the second region 3138 of the third transistor T3 and the second region 4138 of the fourth transistor T4.

The upper boost electrode 3138t of the boost capacitor Cboost overlaps a portion of the first scan line 151 in a plan view (hereinafter also referred to as the lower boost electrode of the boost capacitor Cboost), forming the boost capacitor Cboost.

Referring to FIG. 10, a third gate insulating layer 143 may be located on the oxide semiconductor layer including the channel 3137, first region 3136, and second region 3138 of the third transistor T3, and the channel 4137, first region 4136 and the second region 4138 of the fourth transistor T4, the channel 7137, the first region 7136 and the second region 7138 of the seventh transistor T7, and the upper boost electrode 3138t of the boost capacitor Cboost.

The third gate insulating layer 143 may be located on the entire surface of the oxide semiconductor layer and the first interlayer-insulating layer 161.

Accordingly, the third gate insulating layer 143 may cover the channel 3137, the first region 3136, and the second region 3138 of the third transistor T3, the channel 4137, the first region 4136 and the second region 4138 of the fourth transistor T4, and the top surface and side surfaces of the upper boost electrode 3138t of the boost capacitor Cboost.

However, this embodiment is not limited to this, and the third gate insulating layer 143 may not be located on the entire surface of the oxide semiconductor layer and the first interlayer-insulating layer 161.

For example, the third gate insulating layer 143 may overlap the channel 3137 of the third transistor T3, but may not overlap the first region 3136 and the second region 3138 in a plan view.

Additionally, the third gate insulating layer 143 may overlap the channel 4137 of the fourth transistor T4, but may not overlap the first region 4136 and the second region 4138 in a plan view.

The third gate insulating layer 143 may include an inorganic insulating layer containing silicon oxide (SiOx), silicon nitride (SiNx), or silicon oxynitride (SiONx).

A gate electrode 3151 of the third transistor T3, a gate electrode 4151 of the fourth transistor T4, and a gate electrode 7151 of the seventh transistor T7 are formed on the third gate insulating layer 143.

The gate electrode 3151 of the third transistor T3 may overlap the channel 3137 of the third transistor T3 in a plan view.

The gate electrode 3151 of the third transistor T3 may overlap the lower shielding layer 3155 of the third transistor T3 in a plan view.

The gate electrode 4151 of the fourth transistor T4 may overlap the channel 4137 of the fourth transistor T4 in a plan view.

The gate electrode 4151 of the fourth transistor T4 may overlap the lower shielding layer 4155 of the fourth transistor T4 in a plan view.

The gate electrode 7151 of the seventh transistor T7 may overlap the channel 7137 of the seventh transistor T7 in a plan view.

The third gate conductive layer may further include an upper second scan line 152b, an upper initialization control line 153b, and a bypass control line 154.

The upper second scan line 152b, the upper initialization control line 153b, and the bypass control line 154 may extend approximately in the horizontal direction (e.g., first direction DR1).

The upper second scan line 152b forms the second scan line 152 together with the lower second scan line 152a.

The upper second scan line 152b may be connected to the gate electrode 3151 of the third transistor T3.

The upper second scan line 152b may be integrated with the gate electrode 3151 of the third transistor T3.

The upper initialization control line 153b forms the initialization control line 153 together with the lower initialization control line 153a.

The upper initialization control line 153b may be connected to the gate electrode 4151 of the fourth transistor T4.

The upper initialization control line 153b may be integrated with the gate electrode 4151 of the fourth transistor T4.

The bypass control line 154 may be connected to the gate electrode 7151 of the seventh transistor T7, and the bypass control line 154 may be integrated with the gate electrode 7151 of the seventh transistor T7.

Additionally, the third gate conductive layer may further include a lower second initialization voltage line 128a.

The lower second initialization voltage line 128a may extend approximately in the horizontal direction (e.g., first direction DR1), and a second initialization voltage is applied.

The third gate conductive layer GAT3 may contain a metal or metal alloy such as copper (Cu), molybdenum (Mo), aluminum (Al), or titanium (Ti), and may be composed of a single layer or multiple layers.

A third gate conductive layer including the gate electrode 3151 of the third transistor T3, the gate electrode 4151 of the fourth transistor T4, and the gate electrode 7151 of the seventh transistor T7 are formed through a post-plasma treatment or doping process, the portion of the oxide semiconductor layer covered by the third gate conductive layer is formed into a channel, and the portion of the oxide semiconductor layer not covered by the third gate conductive layer is converted into a conductor.

The channel 3137 of the third transistor T3 may be located under the gate electrode 3151 so as to overlap the gate electrode 3151 in a plan view.

The first region 3136 and the second region 3138 of the third transistor T3 may not overlap the gate electrode 3151 in a plan view.

The channel 4137 of the fourth transistor T4 may be located under the gate electrode 4151 so as to overlap the gate electrode 4151 in a plan view.

The first region 4136 and the second region 4138 of the fourth transistor T4 may not overlap the gate electrode 4151 in a plan view.

The channel 7137 of the seventh transistor T7 may be located under the gate electrode 7151 so as to overlap the gate electrode 7151 in a plan view.

The first region 7136 and the second region 7138 of the seventh transistor T7 may not overlap the gate electrode 7151 in a plan view.

The upper boost electrode 3138t does not overlap the third gate conductive layer in a plan view and may have the same/similar conductivity characteristics as the conductor.

A transistor including an oxide semiconductor layer may have the characteristics of an n-type transistor.

Referring to FIG. 10, the third transistor including the gate electrode 3151 of the third transistor T3, the gate electrode 4151 of the fourth transistor T4, the gate electrode 7151 of the seventh transistor T7, and a second interlayer-insulating layer 162 may be positioned on the gate conductive layer.

The second interlayer-insulating layer 162 may have a single-layer or multi-layer structure.

The second interlayer-insulating layer 162 may include an inorganic insulating material such as silicon nitride (SiNx), silicon oxide (SiOx), or silicon nitride (SiOxNy), and may include an organic material depending on the embodiment.

Two types of openings OP1 and OP2 may be formed on the second interlayer-insulating layer 162.

Two types of openings OP1, OP2 can be formed using different masks.

The opening OP1 is an opening in at least one of the second interlayer-insulating layer 162, the third gate insulating layer 143, the first interlayer-insulating layer 161, the second gate insulating layer 142, and the first gate insulating layer 141, by forming, the first semiconductor layer 130, the first gate conductive layer, or the second gate conductive layer can be exposed.

The opening OP2 forms an opening in the second interlayer-insulating layer 162 and/or the third gate insulating layer 143, and may expose the oxide semiconductor layer or the third gate conductive layer.

One of the openings OP1 overlaps at least a portion of the gate electrode 1151 of the driving transistor T1 in a plan view and is also defined in the third gate insulating layer 143, the first interlayer-insulating layer 161, and the second gate insulating layer 142.

At this time, one of the openings OP1 may overlap the opening 1152 of the first storage electrode 1153 in a plan view and may be located inside the opening 1152 of the first storage electrode 1153.

One of the openings OP2 may overlap at least partially the boost capacitor Cboost in a plan view and may be further formed on the third gate insulating layer 143.

Another one of the openings OP1 overlaps at least a portion of the second region 1133 of the driving transistor T1 in a plan view, and includes the third gate insulating layer 143, the first interlayer-insulating layer 161, and the second gate insulating layer 142 and the first gate insulating layer 141.

Another one of the openings OP2 overlaps at least a portion of the first region 3136 of the third transistor T3 in a plan view and may be formed on the third gate insulating layer 143.

A first data conductive layer including the first connection electrode 1175 and the second connection electrode 3175 may be positioned on the second interlayer-insulating layer 162.

One end of the first connection electrode 1175 may overlap the gate electrode 1151 of the driving transistor T1 in a plan view.

One end of the first connection electrode 1175 may be connected to the gate electrode 1151 of the driving transistor T1 through the opening OP1 and the opening 1152 of the first storage electrode 1153.

The other end of the first connection electrode 1175 may overlap the boost capacitor Cboost in a plan view.

The other end of the first connection electrode 1175 may be connected to the upper boost electrode 3138t of the boost capacitor Cboost through the opening OP2.

Accordingly, the gate electrode 1151 of the driving transistor T1 and the upper boost electrode 3138t of the boost capacitor Cboost may be connected by the first connection electrode 1175.

At this time, the gate electrode 1151 of the driving transistor T1 is connected to the second region 3138 of the third transistor T3 and the second region 4138 of the fourth transistor T4 by the first connection electrode 1175.

One end of the second connection electrode 3175 may overlap the second region 1133 of the driving transistor T1 in a plan view.

One end of the second connection electrode 3175 may be connected to the second region 1133 of the driving transistor T1 through the opening OP1.

The other end of the second connection electrode 3175 may overlap the first region 3136 of the third transistor T3 in a plan view.

The other end of the second connection electrode 3175 may be connected to the first region 3136 of the third transistor T3 through the opening OP2.

Accordingly, the second region 1133 of the driving transistor T1 and the first region 3136 of the third transistor T3 may be connected by the second connection electrode 3175, and the first semiconductor layer 130 and the oxide semiconductor layer are electrically connected.

The first data conductive layer may further include a second initialization voltage line 128b.

The second initialization voltage line 128b includes a wiring portion 128b-1 extending in the vertical direction (e.g., second direction DR2) and a first wiring portion protruding from the wiring portion 128b-1 on opposite sides in the horizontal direction (e.g., first direction DR1). It has a first expansion part 128b-2, and the end of the first expansion part 128b-2 may be expanded.

The extended end of the first expansion part 128b-2 is connected to the lower second initialization voltage line 128a located in the third gate conductive layer, and the seventh transistor T7 located in the oxide semiconductor layer through two different openings OP2 may be electrically connected to the second region 7138.

As a result, the second initialization voltage is transmitted in the horizontal direction (e.g., first direction DR1) through the lower second initialization voltage line 128a located on the third gate conductive layer, and the first data conductive layer is transmitted in the vertical direction (e.g., second direction DR2) through the second initialization voltage line 128b.

Additionally, the second initialization voltage is provided to the second region 7138 of the seventh transistor T7.

The first data conductive layer may further include connection parts 127CM and 171CM, an anode connection electrode ACM1, and an expansion part FL-SD1.

The connection part 127CM is connected to the first initialization voltage line 127 of the second gate conductive layer through the opening OP1, and is connected to a first region 4136 of the second semiconductor layer (oxide semiconductor layer) through the opening OP2, and the first initialization voltage flowing through the first initialization voltage line 127 is transmitted to the fourth transistor T4 of the oxide semiconductor layer.

The connection part 171CM is electrically connected to the end of a portion 1134 of the first semiconductor layer 130-that is, the second transistor T2-through the opening OP1.

The anode connection electrode ACM1 is electrically connected to the end of a portion 1136 of the first semiconductor layer 130-that is, the sixth transistor T6-through the opening OP1.

The expansion part FL-SD1 is formed widely to flatten the anode (referred to "Anode" in the drawings, hereinbelow referred to anode Anode) located at the top.

In addition, the expansion part FL-SD1 is connected to a portion 1135 of the first semiconductor layer 130, that is, the fifth transistor T5, through the opening OP1, and is also electrically connected to the first storage electrode 1153.

The first data conductive layer SD1 may include a metal or metal alloy such as aluminum (Al), copper (Cu), molybdenum (Mo), titanium (Ti), and may be composed of a single layer or multiple layers. there is.

Referring to FIG. 10, the first organic layer 181 may be positioned on the first data conductive layer including the first connection electrode 1175 and the second connection electrode 3175.

The first organic layer 181 may be an organic insulating layer containing an organic material, and the organic material includes one or more materials selected from the group consisting of polyimide, polyamide, acrylic resin, benzocyclobutene, and phenol resin can do.

Referring to FIGS. 6, 7, and 10, the lower organic layer opening OP3 is located in the first organic layer 181.

A second data conductive layer including a data line 171, a driving voltage line 172, and an anode connection electrode ACM2 may be positioned on the first organic layer 181.

A second organic layer 182 and a third organic layer 183 are located on the second data conductive layer, and an anode connection opening OP4 is provided in the second organic layer 182 and the third organic layer 183. It is formed.

The anode connection electrode ACM2 is electrically connected to the anode Anode through the anode connection opening OP4.

FIG. 6 is a plan view showing only the second data conductive layer and the openings OP3, OP4 as it may be difficult to easily recognize the second data conductive layer in FIG. 7, and FIG. 7 shows the second data conductive layer and its surroundings, this is a floor plan showing all floors.

Referring to FIGS. 6 and 7, the lower organic layer opening OP3 overlaps with the connection part 171CM located on the first data challenge layer, the anode connection electrode ACM1, and the expansion part FL-SD1 exposing each of them in a plan view.

The second data conductive layer may include a data line 171, a driving voltage line 172, and an anode connection electrode ACM2.

The data line 171 and the driving voltage line 172 may extend approximately in the vertical direction (e.g., second direction DR2).

The data line 171 is connected to the connection part 171 CM of the first data conductive layer through the lower organic layer opening OP3, and is connected to the second transistor T2 through this.

The data line 171 extends in the vertical direction and has a structure in which it is bent, and the data line 171 at the bent portion may form the boundary of the secondary optical sensor area OPS.

A plurality of adjacent optical sensor areas OPS may form one first component area EA1.

The driving voltage line 172 is electrically connected to the fifth transistor T5 and the first storage electrode 1153 through the lower organic layer opening OP3 and the expansion part FL-SD1 of the first data conductive layer.

The anode connection electrode ACM2 is electrically connected to the anode connection electrode ACM1 of the first data conductive layer through the opening OP3, and is electrically connected to the sixth transistor T6.

Referring to FIG. 6, the driving voltage line 172 further includes an extension portion FL-SD2 and a protruding wiring portion 172-e, and has a structure that is not formed in the portion where the anode connection electrode ACM2 is formed.

The expansion part FL-SD2 is formed widely to flatten the anode (Anode) located at the top.

Meanwhile, two protruding wiring portions 172-e of the driving voltage line 172 are formed on opposite sides of the two data lines 171 to flatten the anode Anode located above them, resulting in a total of four wiring structures 171, 172-e has a structure such that it is located at the bottom of the anode Anode.

Referring to FIG. 7, two data lines 171 formed adjacent to each other are bent in opposite directions and have a portion with a large gap, and this portion corresponds to the secondary optical sensor area OPS.

One secondary optical sensor area OPS is located between two adjacent pixel circuit units.

The left and right boundaries of the secondary optical sensor area OPS are composed of two data lines 171, and the lower border is formed by the first scan line 151, and the lower second scan line 152a and/or the second scan line 152a, the upper boundary can be formed by the scan line 152b.

Depending on the embodiment, a portion 1134 of the first semiconductor layer 130 that overlaps the data line 171 in a plan view form the left and right boundaries of the secondary optical sensor area OPS.

The structure of the lower part of the anode Anode as described above (the expansion part FL-SD1 and the wiring portion 128b-1 of the first data conductive layer, the expansion part FL-SD2 of the second data conductive layer, and the data line 171), and the wiring portion 172-e and the organic layers 181, 182, and 183 provide the anode Anode with planarization characteristics.

In this embodiment, the expansion parts FL-SD1 and FL-SD2 are electrically connected to the driving voltage line 172 to transmit the driving voltage ELVDD.

The second data conductive layer SD2 may include a metal or metal alloy such as aluminum (Al), copper (Cu), molybdenum (Mo), or titanium (Ti), and may be composed of a single layer or multiple layers.

Referring to FIG. 10, the second organic layer 182 and the third organic layer 183 are located on the second data conductive layer.

The second organic layer 182 and the third organic layer 183 may be organic insulating layers and may include one or more materials selected from the group consisting of polyimide, polyamide, acrylic resin, benzocyclobutene, and phenol resin.

Depending on the embodiment, the third organic layer 183 may be omitted.

An anode connection opening OP4 is formed in the second organic layer 182 and the third organic layer 183, through which the anode Anode and the anode connection electrode ACM2 are electrically connected.

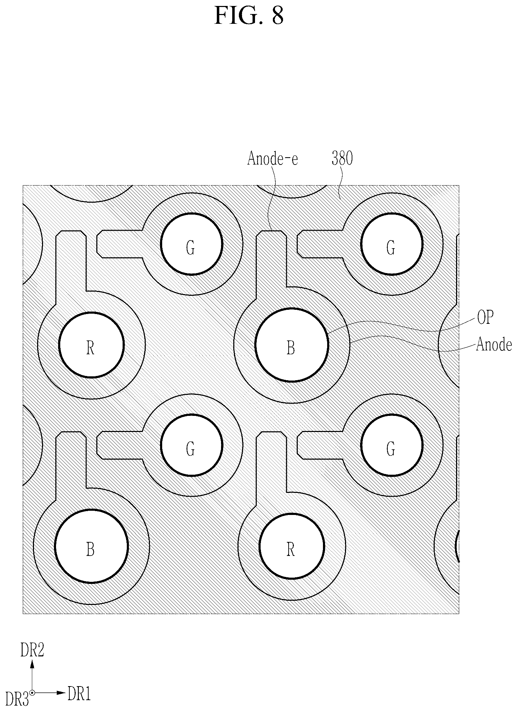

Referring to FIG. 8 to FIG. 10, an anode Anode is formed on the third organic layer 183.

The anode Anode may further include an expansion part Anode-e to receive current from the pixel circuit part through the anode connection opening OP4.

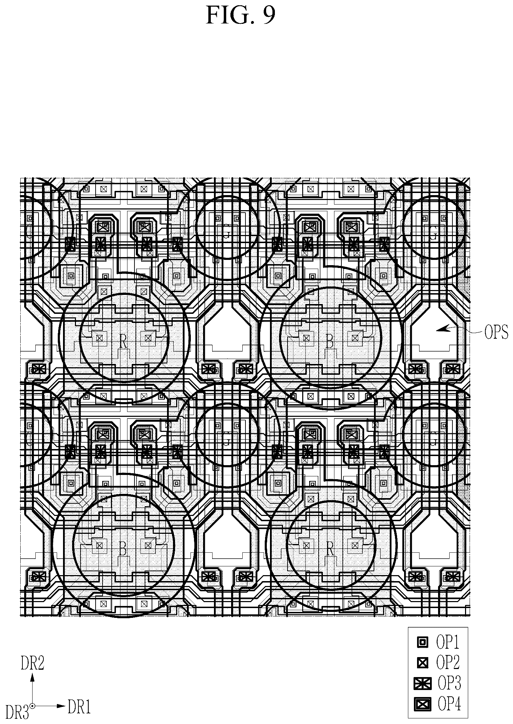

Referring to FIG. 9, two anode connection openings OP4 are located adjacent to each other, one of which has an expansion part Anode-e extending in the first direction DR1 and included in the green light emitting diode, one is connected to the anode Anode, and the other expansion part Anode-e may have a structure extending in the second direction and connected to the anode Anode included in the blue- or red-light emitting diode.

Referring to FIG. 9 and FIG. 10, the black pixel defining layer 380 is located on the anode Anode, and the opening OP of the black pixel defining layer 380 is formed to overlap the anode Anode in a plan view.

The expansion part Anode-e of the anode Anode is not exposed by the opening OP of the black pixel defining layer 380 and has a structure that overlaps the black pixel defining layer 380 in a plan view.

As a result, the anode connection opening OP4 also has a structure that overlaps the black pixel defining layer 380 in a plan view.

Referring to FIG. 10, since the anode connection opening OP4 does not overlap the opening OP of the black pixel defining layer 380 and the opening OPBM of the light blocking layer 220 in a plan view, it can be seen that the structure overlaps the black pixel defining layer 380 and the light blocking layer 220 in a plan view.

In addition, a portion of the lower organic layer openings OP3 (the first lower organic layer opening) overlaps at least a portion of the opening OPBM of the light blocking layer 220 in a plan view, and the remaining lower organic layer openings OP3-i.e., the second lower organic layer openings OP3-overlap the opening OPBM of the light blocking layer 220, the lower organic layer opening overlaps the light blocking layer 220 in a plan view.

Meanwhile, all lower organic layer openings OP3 overlap the black pixel defining layer 380 in a plan view.

In addition, in this embodiment, at least one of the anodes Anode that is the portion exposed through the opening OP of the black pixel defining layer 380 may be formed to be flat.

Based on the above planar structure, the cross-sectional structure of the display area, first component area EA1, and secondary optical sensor area OPS of the light emitting display device will be explained through FIG. 10.

FIG. 10 is a cross-sectional view of a display panel of a light emitting display device according to an embodiment.

In FIG. 10, in addition to the stacked structure of the display area DA, the stacked structure of the first component area EA1 is shown.

Among the detailed stacked structures of the pixels in the display area DA shown in FIG. 10, the anode Anode is explained together by looking at FIG. 6 to FIG. 9.

In the embodiment of FIG. 10, the pixel circuit unit includes the second organic layer 182 and the third organic layer 183, and refers to the lower portion, and the light emitting diode is the upper portion of the third organic layer 183. This may refer to a configuration located in the lower part of the encapsulation layer 400.

Referring to FIG. 10, the stacked structure on the anode Anode in the pixel of the display area DA is as follows.

A black pixel defining layer 380 may be positioned on the anode Anode, which has an opening OP exposing the anode Anode and covers at least a portion of the anode Anode.

The black pixel defining layer 380 is formed of a black organic material to prevent light applied from the outside from being reflected back to the outside.

Depending on the embodiment, the black pixel defining layer 380 may include a negative-type black organic material and may include a black pigment.

Meanwhile, depending on the embodiment, a pixel defining layer formed of a highly transparent material may be used instead of the black pixel defining layer 380.

Here, as materials with high transparency, general-purpose polymers such as polystyrene PS or imide-based polymers such as polyimide PI can be used, in addition, polymethylmethacrylate PMMA, polymer derivatives with phenolic groups, and acrylic-based polymers can be used, and may include organic insulating materials such as polymers, acrylic polymers, and siloxane polymers.

The spacer 385 is located on the black pixel defining layer 380.

Unlike the black pixel defining layer 380, the spacer 385 may be formed of a transparent organic insulating material.

Depending on the embodiment, the spacer 385 may be formed of a positive-type transparent organic material.

A functional layer FL and a cathode (referred to "Cathode" in the drawings, hereinafter referred to cathode Cathode) are sequentially formed on the anode, spacer 385, and black pixel defining layer 380, and the display area DA and first component area EA1 in the functional layer FL and the cathode Cathode can be located in the entire area.

The light emitting layer EML is located between the functional layers FL, and the light emitting layer EML may be located only within the opening OP of the black pixel defining layer 380.

Hereinafter, the functional layer FL and the light emitting layer EML can be combined and referred to as the intermediate layer.

The functional layer FL may include at least one of the auxiliary layers such as an electron injection layer, electron transport layer, hole transport layer, and hole injection layer, and the hole injection layer and hole transport layer may be located below the light emitting layer EML, and the electron transport layer and electron injection layer may be located above the light emitting layer EML.

The encapsulation layer 400 is located on the cathode Cathode.

The encapsulation layer 400 includes at least one inorganic layer and at least one organic layer, and depending on the embodiment, may have a triple-layer structure including a first inorganic encapsulation layer, an organic encapsulation layer, and a second inorganic encapsulation layer.

The encapsulation layer 400 may be used to protect the light emitting layer EML from moisture or oxygen that may enter from the outside.

Depending on the embodiment, the encapsulation layer 400 may include a structure in which an inorganic layer and an organic layer are further sequentially stacked.

In the embodiment of FIG. 10, sensing insulating layers 501, 510, and 511 and a plurality of sensing electrodes 540 and 541 are positioned on the encapsulation layer 400 for touch sensing.

In the embodiment of FIG. 10, touch can be sensed in a capacitive manner using two sensing electrodes 540 and 541.

Specifically, a first sensing insulating layer 501 is formed on the encapsulation layer 400, and a plurality of sensing electrodes 540 and 541 are formed thereon.

The plurality of sensing electrodes 540 and 541 may be insulated with the second sensing insulating layer 510 interposed therebetween, and some of them may be electrically connected through an opening located in the sensing insulating layer 510.

Here, the sensing electrodes 540 and 541 are made of metal or metal alloy such as aluminum (Al), copper (Cu), silver (Ag), gold (Au), molybdenum (Mo), titanium (Ti), and tantalum TA, and may include a single layer or multiple layers.

A third sensing insulating layer 511 is formed on the sensing electrode 540.

A light blocking layer 220 and a color filter 230 are located on the upper sensing electrode 540 and the third sensing insulating layer 511.

The light blocking layer 220 may be positioned to overlap the sensing electrodes 540 and 541 in a plan view, and may be positioned not to overlap the anode Anode in a plan view.

This is to ensure that the anode Anode capable of displaying an image is not obscured by the light blocking layer 220 and the sensing electrodes 540 and 541 in the plan view.

A color filter 230 may be positioned on the third sensing insulating layer 511 and the light blocking layer 220.

The color filter 230 includes a red-color filter that transmits red light, a green-color filter that transmits green light, and a blue-color filter that transmits blue light.

Each color filter 230 may be positioned to overlap the anode Anode of the light emitting diode in a plan view.

Light emitted from the light emitting layer EML may be changed to the corresponding color as it passes through a color filter.

The light blocking layer 220 may be positioned between each color filter 230.

Depending on the embodiment, the color filter 230 may be replaced with a color conversion layer or may further include a color conversion layer.

The color conversion layer may include quantum dots.

Additionally, depending on the embodiment, there may be a reflection adjustment layer that fills the opening OPBM of the light blocking layer 220 instead of the color filter 230.

The reflection adjustment layer may have a structure that covers the light blocking layer 220.

A planarization layer 550 covering the color filter 230 may be positioned on the color filter 230, and since the color filter 230 and the light blocking layer 220 serve to prevent reflection of external light, an additional polarizer is not attached.

Meanwhile, FIG. 10 also shows the cross-sectional structure of the first component area EA1.

The first component area EA1 is an area where a plurality of secondary optical sensor areas OPS are located in the lower panel layer, and in some areas, the same pixel circuit structure as the display area DA is formed, but in FIG. 10, the display area focuses on the cross-sectional structure of the secondary optical sensor area OPS, which is different from the display area DA.

Meanwhile, a secondary optical sensor area OPS may be located in the display area DA, but all secondary optical sensor areas OPS in the display area DA include the black pixel defining layer 380 and/or the light blocking layer 220, so it is blocked and light does not pass therethrough.

The first component area EA1 includes a secondary optical sensor area OPS through which light can pass, and in the secondary optical sensor area OPS, no conductive layer or semiconductor layer is located so that light can pass therethrough. At a certain position corresponding to the secondary optical sensor area OPS, additional openings OP-1, OPBM-1 are defined in the black pixel defining layer 380 so that light can pass therethrough, and at another position corresponding to the secondary optical sensor area OPS, the light blocking layer 220 is located at the top of the optical sensor area OPS, and it can have a structure that does not block light.

Meanwhile, a portion of the secondary optical sensor area OPS located in the first component area EA1 is formed to overlap the black pixel defining layer 380 and/or the light blocking layer 220 in a plan view that light does not pass through.

In this way, some of the plurality of secondary optical sensor areas OPS located in the first component area EA1 are formed so that light can pass therethrough, and the rest are formed so that light cannot pass therethrough.

Here, the secondary optical sensor area OPS that can transmit light in the first component area EA1 is called the "first optical sensor area or transmissive optical sensor area," and the secondary optical sensor area OPS can be referred to as "second optical sensor area or non-transmissive optical sensor area."

In this way, if the number of the first optical sensor area OPS1 and the second optical sensor area OPS2 is adjusted in one first component area EA1, it is possible for the sensor located on the back of the first component area EA1 to detect the front surface of the light emitting display device and additionally improve the color of light reflection in the first component area EA1.

Meanwhile, depending on the embodiment, the first component area EA1 may have a different reflectance or reflection color from the display area surrounding the first component area EA1, thereby preventing the first component area EA1 from being visible to the user.

In this embodiment, a light blocking layer 220 and/or a black pixel defining layer 380 is located on the front of the secondary optical sensor area OPS located between adjacent pixel circuit units, and the light blocking layer 220 and/or the black pixel defining layer 380 has additional openings OPBM-1, OP-1 that overlap in a plan view with the secondary optical sensor area OPS of the first optical sensor area OPS1. Since no additional opening is formed in the secondary optical sensor area OPS of the second optical sensor area OPS2, the light blocking layer 220 and/or the black pixel defining layer 380 and the secondary optical sensor area OPS may have a structure in which they overlap in a plan view.

Meanwhile, depending on the embodiment, when a transparent pixel defining layer is used instead of the black pixel defining layer 380, the pixel defining layer may not have an opening in the first optical sensor area OPS1 and the second optical sensor area OPS2.

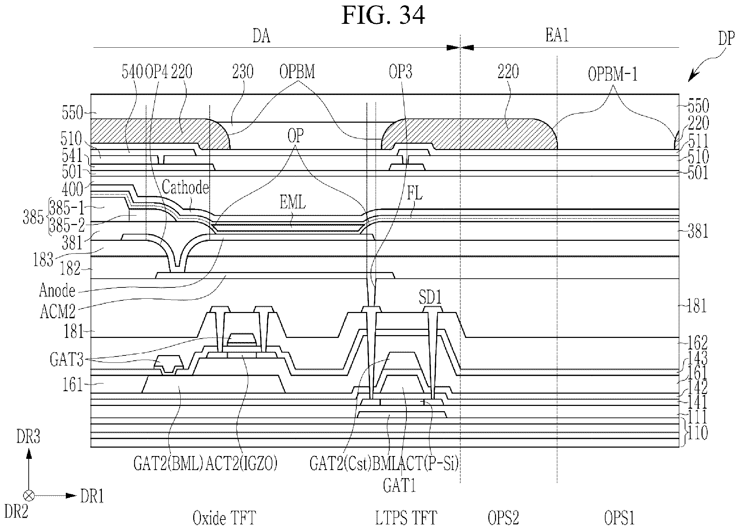

The corresponding embodiment is explained in FIG. 34.

Specifically, based on FIG. 10, the stacked structure of the first component area EA1 according to an embodiment is as follows.

The buffer layer 111, which is an inorganic insulating layer, is positioned on the substrate 110, and the first gate insulating layer 141 and a second gate insulating layer 142, which are inorganic insulating layers, are sequentially positioned thereon.

Additionally, the first interlayer-insulating layer 161, a third gate insulating layer 143, and a second interlayer-insulating layer 162, which are inorganic insulating layers, are sequentially stacked on the second gate insulating layer 142.

The first organic layer 181, a second organic layer 182, and a third organic layer 183, which are organic insulating layers, are sequentially stacked on the second interlayer-insulating layer 162.

The stacked structure from the substrate 110 to the anode Anode -that is, to the third organic layer 183 in the embodiment of FIG. 10-may correspond to the secondary optical sensor area OPS.

As described above, the metal layer BML, a first semiconductor layer ACT1, a first gate conductive layer GAT1, a second gate conductive layer GAT2, an oxide semiconductor layer ACT2, a third gate conductive layer GAT3, a first data conductive layer SD1, and the second data conductive layer SD2 are not located in the above secondary optical sensor area OPS.

The secondary optical sensor area OPS is divided into a first optical sensor area OPS1 formed at the top so that light can pass therethrough, and a second optical sensor area OPS2 formed so that light cannot pass therethrough.

The upper layered structure of the first optical sensor area (OPS1; transmission-type optical sensor area) through which light passes through may be as follows.

An additional opening OP-1 of the black pixel defining layer 380 is located on the third organic layer 183, which is the secondary optical sensor area OPS, and has a structure through which light can pass.

Therefore, the functional layer FL may be located on the third organic layer 183, and a cathode may be located on the third organic layer 183.

The encapsulation layer 400 is positioned on the cathode Cathode, and sensing insulating layers 501, 510, and 511 are sequentially positioned on top of the cathode Cathode.

The encapsulation layer 400 may have a triple-layer structure including a first inorganic encapsulation layer, an organic encapsulation layer, and a second inorganic encapsulation layer.

Additionally, the sensing insulating layers 501, 510, and 511 may all be inorganic insulating layers.

An additional opening OPBM-1 of the light blocking layer 220 is located on the third sensing insulating layer 511.

Therefore, the light blocking layer 220 and the black pixel defining layer 380 are not formed in the first optical sensor area OPS1 of the first component area EA1 through which light passes, so light can pass therethrough.

The planarization layer 550 may be positioned on the third sensing insulating layer 511 in the first optical sensor area OPS1.

Meanwhile, the stacked structure of the second optical sensor area (OPS2; non-transmissive optical sensor area) through which light does not pass may be as follows.

The black pixel defining layer 380 is located on the third organic layer 183, which is the secondary optical sensor area OPS, and has no additional opening, so it may have a structure through which light cannot pass.

The functional layer FL, the cathode Cathode, and the encapsulation layer 400 are sequentially positioned on the black pixel defining layer 380, and sensing insulating layers 501, 510, and 511 are sequentially positioned on the black pixel defining layer 380.

The encapsulation layer 400 may have a triple-layer structure including a first inorganic encapsulation layer, an organic encapsulation layer, and a second inorganic encapsulation layer.

Additionally, the sensing insulating layers 501, 510, and 511 may all be inorganic insulating layers.

The light blocking layer 220 is located on the third sensing insulating layer 511 and has no additional opening, so it may have a structure through which light cannot pass.

Therefore, the second optical sensor area (OPS2; non-transmissive optical sensor area) in the first component area EA1 through which light does not pass overlaps the light blocking layer 220 and/or the black pixel defining layer 380 in a plan view, and therefore, light cannot pass therethrough.

The planarization layer 550 may be positioned on the light blocking layer 220 in the second optical sensor area OPS2.

In the above example, a total of three organic layers are formed, and an anode connection opening is formed in the second organic layer and the third organic layer.

However, at least two organic layers may be formed, and in this case, the anode connection opening may be located in the upper organic layer located away from the substrate, and the lower organic layer opening may be located in the lower organic layer.

In the above, the cross-sectional structures of the first optical sensor area OPS1 and the second optical sensor area OPS2 included in the first component area EA1 in the overall light emitting display device were explained.

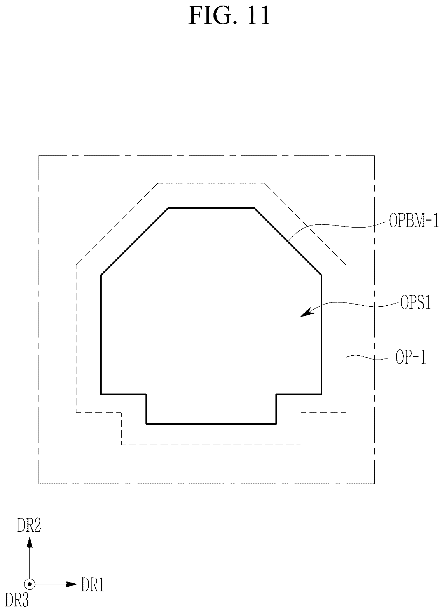

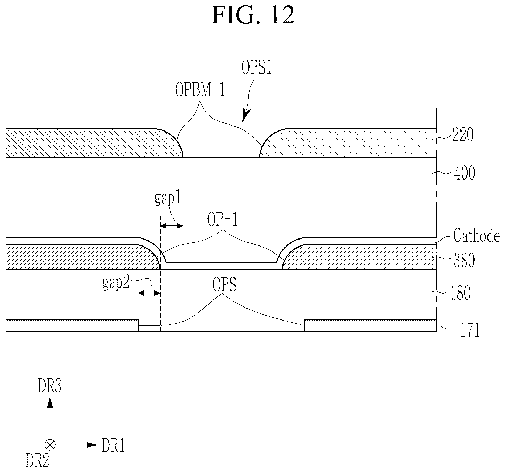

Hereinafter, the specific planar structure and cross-sectional structure of the first optical sensor area OPS1 in the first component area EA1 will be explained through FIG. 11 and FIG. 12.

FIG. 11 is a plan view of the first optical sensor area of the first component area according to an embodiment, and FIG. 12 is a cross-sectional view of the first optical sensor area of the first component area of FIG. 11.

First, referring to FIG. 11, the first optical sensor area OPS1 located in the first component area EA1 can include an additional opening OPBM-1 of the light blocking layer 220 and an additional opening OP-1 of the black pixel defining layer 380.

In FIG. 11, the secondary optical sensor area OPS located in the pixel circuit unit is not shown, and only the structure of the light blocking layer 220 and the black pixel defining layer 380 located above it is shown.

Referring to FIG. 11, the additional opening OPBM-1 of the light blocking layer 220 has a smaller area than the additional opening OP-1 of the black pixel defining layer 380, so that when viewed from the front (i.e., in a plan view), the black pixel defining layer 380 has a structure that is obscured by the light blocking layer 220.

In FIG. 11, the additional opening OP-1 of the black pixel defining layer 380 is shown as a dotted line, which is obscured by the light blocking layer 220 when viewed from the front (i.e., in a plan view).

Meanwhile, in FIG. 11, the additional opening OP-1 of the black pixel defining layer 380 may have a maximum horizontal and vertical width of 5 µm to 15 µm, respectively.

In addition, the gap between the additional opening OP-1 of the black pixel defining layer 380 and the additional opening OPBM-1 of the light blocking layer 220 may be 1 µm to 2 µm, which may cause misalignment of the black pixel definition, so it is possible to prevent the additional opening OP-1 of the black pixel defining layer 380 from being obscured.

The shape of the additional opening OP-1 of the black pixel defining layer 380 shown in FIG. 11 may be formed in various shapes such as a circle or a polygon, unlike FIG. 11.

The relationship between the additional opening OPBM-1 of the light blocking layer 220 and the additional opening OP-1 of the black pixel defining layer 380 is also shown in detail in FIG. 12.

In FIG. 12, the organic layer 180 constituting a portion of the pixel circuit unit and the data line 171 located in the second data conductive layer are schematically shown.

Here, the organic layer 180 may be an organic layer shown by combining the organic layers 181, 182, and 183 of FIG. 10 into one.

Referring to FIG. 12, the additional opening OPBM-1 of the light blocking layer 220 has a narrower width than the additional opening OP-1 of the black pixel defining layer 380, so that in a plan view, the black pixel defining layer 380 has a structure that is obscured by the light blocking layer 220 in a plan view.

That is, the end of the black pixel defining layer 380 is positioned inward from the end of the light blocking layer 220 with a first horizontal gap gap1.

A cathode Cathode is located on the black pixel defining layer 380. The cathode Cathode located on the inclined surface of the black pixel defining layer 380 is also not exposed through the additional opening OPBM-1 of the light blocking layer 220, and it has a structure that is hidden by the light blocking layer 220.

As a result, even if external light enters the additional opening OPBM-1 of the light blocking layer 220, it is not reflected from the cathode Cathode located on the inclined surface of the black pixel defining layer 380, so the light blocking layer 220 is visible to the user's eyes, the location of the additional opening OPBM-1 is not recognized.

For reference, external light can be incident and reflected on the cathode Cathode located on the organic layer 180, but only light that is close to vertical can be incident on and reflected by the cathode Cathode, so it is not substantially visible to the user's eyes.

Meanwhile, since the cathode Cathode located on the inclined surface of the black pixel defining layer 380 reflects external light at various angles and can be easily seen by the user, in this embodiment, the cathode Cathode located on the inclined surface of the black pixel defining layer 380 is covered with the light blocking layer 220 so that the position of the additional opening OPBM-1 of the light blocking layer 220 is not recognized.

Meanwhile, referring to FIG. 12, the width of the secondary optical sensor area OPS of the pixel circuit portion divided by the data line 171 is the width of the additional opening OPBM-1 of the light blocking layer 220, and it may be formed to be larger than the width of the additional opening OP-1 of the black pixel defining layer 380.

In other words, the end of the data line 171 can be positioned inward from the end of the black pixel defining layer 380 by a second horizontal distance gap2, and from the end of the light blocking layer 220, it is positioned inward by the sum of the first horizontal distance gap1 and the second horizontal distance gap2.

As a result, the data line 171 is obscured by the light blocking layer 220 and the black pixel defining layer 380 in a plan view, and external light is not reflected from the data line 171, so that the position of the additional opening OPBM-1 of the light blocking layer 220 is not visible to the user's eyes.

Therefore, the embodiments of FIG. 11 and FIG. 12 have the advantage that the user cannot easily check where the first optical sensor area OPS1 is located and cannot distinguish it from other display areas DA.

Referring to FIG. 10, the color filter 230 is located on the light blocking layer 220 in the display area DA, but referring to FIG. 12, the color filter may not be located in the first optical sensor area OPS1.

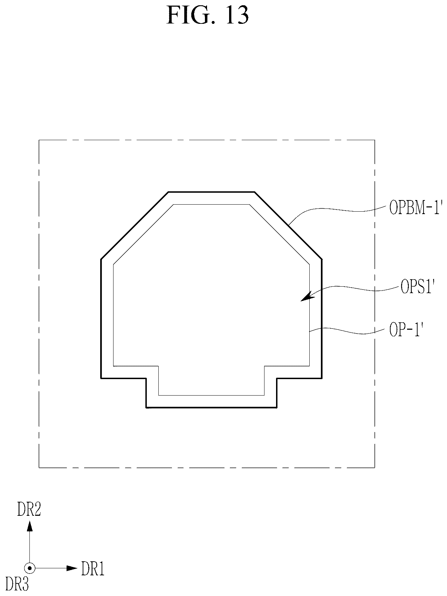

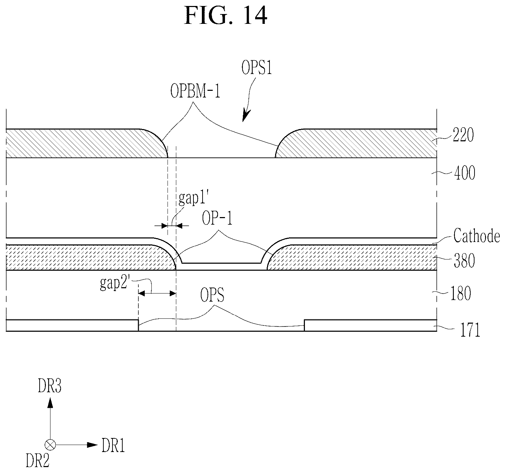

The embodiments of FIG. 11 and FIG. 12 will be compared with the comparative example through FIG. 13 and FIG. 14.

FIG. 13 is a plan view of the first optical sensor area of the first component area according to a comparative example, and FIG. 14 is a cross-sectional view of the first optical sensor area of the first component area of FIG. 13.

In FIG. 13 and FIG. 14, the additional opening OPBM-1 of the light blocking layer 220 has a larger area than the additional opening OP-1 of the black pixel defining layer 380.

Referring to FIG. 13, the additional opening OP-1 of the black pixel defining layer 380 is located within the additional opening OPBM-1 of the light blocking layer 220 and is not covered by the light blocking layer 220, so it is shown as a solid line.

Referring to FIG. 13, the additional opening OP-1 of the black pixel defining layer 380 is located within the additional opening OPBM-1 of the light blocking layer 220 and is not covered by the light blocking layer 220, so it is shown as a solid line.

In addition, referring to FIG. 14, the additional opening OPBM-1 of the light blocking layer 220 has a greater width than the additional opening OP-1 of the black pixel defining layer 380, so that in a plan view, it defines the black pixel, and a cathode Cathode located on the inclined surface of the black pixel defining layer 380 is exposed.

That is, the end of the black pixel defining layer 380 protrudes from the end of the light blocking layer 220 by the 1-1 horizontal gap gap1'.

As a result, after the external light enters through the additional opening OPBM-1 of the light blocking layer 220, it is reflected from the cathode Cathode located above the inclined surface of the black pixel defining layer 380, making it easy for the user's eye to recognize the position of the additional opening OPBM-1 of the light blocking layer 220.

Therefore, in the comparative example, there is a disadvantage in that the user can easily check where the first optical sensor area OPS1 is located and distinguish it from other display areas DA.

Meanwhile, in the comparative example of FIG. 14, the end of the data line 171 may be located inward from the end of the black pixel defining layer 380 by the sum of the 2-1 horizontal gap gap2', and the light blocking layer 220 may be located inward from the end of the 2-1 horizontal gap gap2' minus the 1-1 horizontal gap gap1'.

In FIG. 11 and FIG. 12, the black pixel defining layer 380 and the cathode Cathode located on the inclined surface of the black pixel defining layer 380 have a structure that is obscured by the light blocking layer 220 in a plan view.

However, depending on the embodiment, a plurality of color filters may be overlapped instead of the light blocking layer 220 to cover the black pixel defining layer 380 and the cathode Cathode located on the inclined surface thereof.

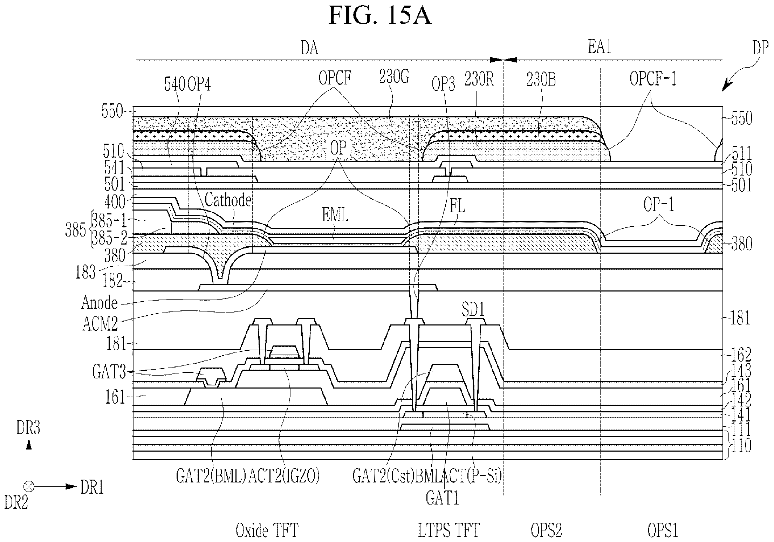

FIG. 15A is a cross-sectional view of a display panel of a light emitting display device according to another embodiment.

This embodiment will be explained through FIG. 15A to FIG. 19.

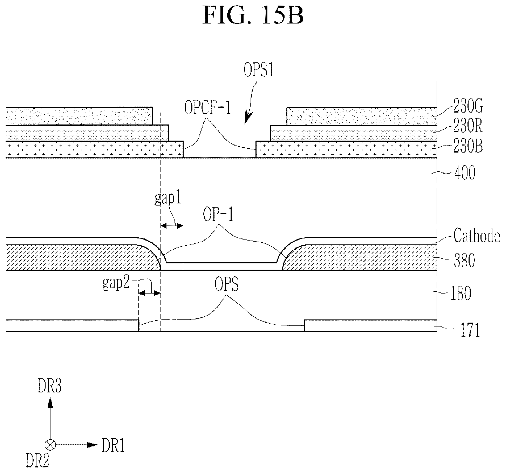

FIG. 15B to FIG. 19 are cross-sectional views of the first optical sensor area of the first component area according to other embodiments.

First, the embodiment of FIGS. 15A and 15B will be explained.

In FIGS. 15A and 15B, the light blocking layer 220 and the additional opening OPBM-1 of the light blocking layer 220 are not formed, and a plurality of color filters 230R, 230G, and 230B are located at that position, and a plurality of color filters 230R, 230G, and 230B have an additional opening OPCF-1 formed compared to FIGS. 10 and 12.

Since the light blocking layer 220 is replaced by a plurality of color filters 230R, 230G, and 230B, the light blocking layer 220 may not be located on the black pixel defining layer 380 even in the display area DA.

FIGS. 15A and 15B are drawings corresponding to FIGS. 10 and 12, respectively, and the top view of the embodiment of FIG. 15B may be similar to FIG. 11, and in FIG. 11, an additional opening OPBM-1 of the light blocking layer 220 may be an additional opening OPCF-1 of the plurality of color filters 230R, 230G, and 230B.

Referring to FIG. 15B, the additional opening OPCF-1 of the plurality of color filters 230R, 230G, 230B has a narrower width than the additional opening OP-1 of the black pixel defining layer 380 when viewed from the front (i.e., in a plan view), the black pixel defining layer 380 has a structure that is obscured by a plurality of color filters 230R, 230G, and 230B in a plan view.

That is, the end of the black pixel defining layer 380 is positioned with a first horizontal gap gap1 inward from the end of the plurality of color filters 230R, 230G, and 230B.

The gap between the additional opening OP-1 of the black pixel defining layer 380 and the additional opening OPCF-1 of the plurality of color filters 230R, 230G, 230B may be equal to or more than 1 µm and equal to or less than 2 µm.

A cathode Cathode is located on the black pixel defining layer 380, and the cathode Cathode located on the slope of the black pixel defining layer 380 also provides additional openings OPCF-1 for the plurality of color filters 230R, 230G, and 230B. It has a structure that is not exposed but is covered by multiple color filters 230R, 230G, 230B.

As a result, even if external light enters the additional opening OPCF-1 of the plurality of color filters 230R, 230G, 230B, it is not reflected from the cathode Cathode located on the inclined surface of the black pixel defining layer 380, so it does not affect the user's eyes, and the position of the additional opening OPCF-1 of the plurality of color filters 230R, 230G, 230B is not recognized.

Referring to FIG. 15B, the end of the cathode Cathode located on the inclined surface of the black pixel defining layer 380 is a blue-color filter 230B and a red-color filter 230R among the three color filters 230R, 230G, 230B, it is located inside the end of the green-color filter 230G and may be located outside the green-color filter 230G.

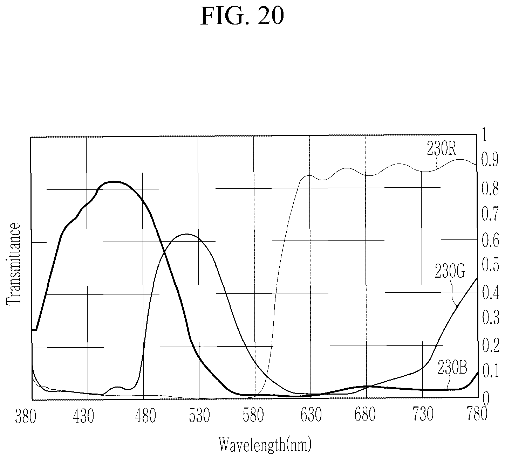

That is, the cathode Cathode located on the inclined surface of the black pixel defining layer 380 has a structure that is obscured by the blue-color filter 230B and the red-color filter 230R in a plan view because, referring to FIG. 20, when the blue-color filter 230B and the red-color filter 230R are overlapped in a plan view, most of the light can be blocked, thereby performing a role equivalent to a light blocking layer.

Meanwhile, referring to FIG. 15B, the width of the secondary optical sensor area OPS of the pixel circuit section divided by the data line 171 is the width of the additional opening OPCF-1 of the plurality of color filters 230R, 230G, 230B, the width may be greater than that of the additional opening OP-1 of the black pixel defining layer 380.

That is, the end of the data line 171 may be located inward by the second horizontal gap gap2 from the end of the black pixel defining layer 380, and from the ends of the plurality of color filters 230R, 230G, and 230B, it is located inward by the sum of the first horizontal gap gap1 and the second horizontal gap gap2.

As a result, the data line 171 is obscured by a plurality of color filters 230R, 230G, 230B and the black pixel defining layer 380 in a plan view, and external light is not reflected from the data line 171, creating a plurality of visual effects in the user's eyes, and the position of the additional opening OPCF-1 of the color filters 230R, 230G, 230B is not recognized.

Therefore, the embodiment of FIG. 15B has the advantage that the user cannot easily check where the first optical sensor area OPS1 is located and cannot distinguish it from other display areas DA.

In the embodiment of FIG. 15B, the plurality of color filters 230R, 230G, and 230B have a stacked structure with a blue-color filter 230B located at the bottom, a red-color filter 230R located above it, and a green-color filter 230G located at the top.

In addition, the blue-color filter 230B has the narrowest additional opening in a cross-sectional view, so that the additional opening of the blue-color filter 230B can correspond to the additional opening OPCF-1 of the plurality of color filters 230R, 230G, and 230B.

The red-color filter 230R may have an additional opening larger than the blue-color filter 230B, and the green-color filter 230G may have an additional opening larger than the red-color filter 230R and the blue-color filter 230B.

More specifically, among the red-color filter 230R and blue-color filter 230B that affect color, especially black color, the end of the color filter located relatively above at least matches the end of the black pixel defining layer 380, or it can be located inside it.

As a result, another color filter located on the lower side may be located inward by gap1 from the end of the black pixel defining layer 380.

However, the stacked structure of the plurality of color filters 230R, 230G, and 230B as described above may be changed in various ways.

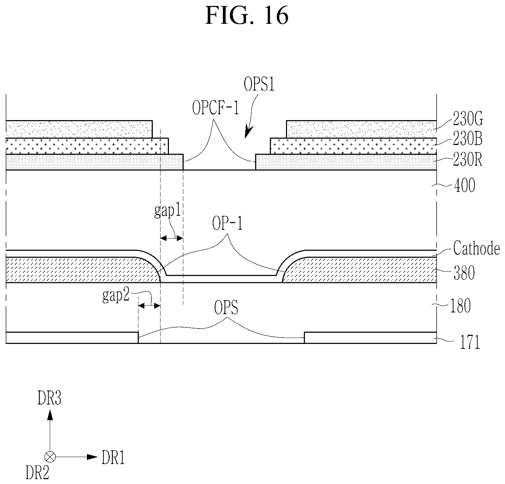

The embodiment of FIG. 16 shows one of various stacked structures.

FIG. 16 has a stacked structure in which the red-color filter 230R is located at the bottom, the blue-color filter 230B is located above it, and the green-color filter 230G is located at the top.

In addition, the red-color filter 230R has the narrowest additional opening in a cross-sectional view, so that the additional opening of the red-color filter 230R can correspond to the additional opening OPCF-1 of the plurality of color filters 230R, 230G, and 230B.

The blue-color filter 230B may have an additional opening larger than the red-color filter 230R, and the green-color filter 230G may have an additional opening larger than the red-color filter 230R and the blue-color filter 230B.

Referring to FIG. 15B and FIG. 16, the additional opening of the color filter located at the bottom of the plurality of color filters 230R, 230G, and 230B is formed to be the narrowest, the additional opening of the color filter located at the top of the plurality of color filters 230R, 230G, and 230B is formed to be largest, and the additional opening of the color filter located in the middle of the plurality of color filters 230R, 230G, and 230B may be formed to be of medium size.

In the embodiment of FIG. 16, like the embodiment of FIG. 15B, the end of the cathode Cathode located on the inclined surface of the black pixel defining layer 380 is a blue-color filter 230B among the three color filters 230R, 230G, 230B and may be located inside the end of the red-color filter 230R, and may be located outside the green-color filter 230G.

That is, the cathode Cathode located on the inclined surface of the black pixel defining layer 380 has a structure that is obscured by the blue-color filter 230B and the red-color filter 230R in a plan view. Referring to FIG. 20, this is because by overlapping the blue-color filter 230B and the red-color filter 230R in a plan view, most of the light can be blocked, thereby performing a role equivalent to a light blocking layer.

Meanwhile, depending on the embodiment, the number of color filters included in the plurality of color filters does not need to be three.

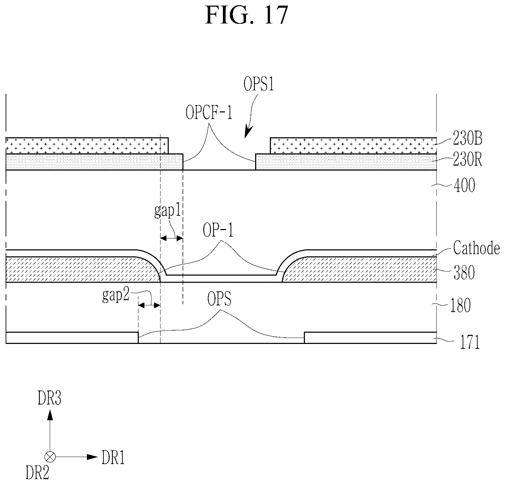

One of them, an embodiment using two color filters, is shown in FIG. 17.

In the embodiment of FIG. 17, the plurality of color filters include only the red-color filter 230R and the blue-color filter 230B, and do not include the green-color filter 230G.

Depending on the embodiment, color filters of different colors may not be included, and may be formed using only one color filter.

The embodiment of FIG. 17 has a stacked structure in which the red-color filter 230R is located at the bottom, and the blue-color filter 230B is located above it.

Additionally, the red-color filter 230R has the narrowest additional opening, so that the additional opening of the red-color filter 230R can correspond to the additional opening OPCF-1 of the plurality of color filters 230R and 230B.

The blue-color filter 230B may have an additional opening of which area is larger than an area of the red-color filter 230R in a plan view.

That is, the additional opening of the color filter located at the bottom of the blue-color filter 230B and the red-color filter 230R may be formed to be narrower than the additional opening of the color filter located at the top in a cross-sectional view.

In the embodiment FIG. 17, like the embodiment of FIG. 15B, the end of the cathode Cathode located on the inclined surface of the black pixel defining layer 380 is smaller than the ends of the blue-color filter 230B and the red-color filter 230R, the cathode Cathode located inside and on the inclined surface of the black pixel defining layer 380 has a structure that is obscured by the blue-color filter 230B and the red-color filter 230R in a plan view. As shown in FIG. 20, for reference, if the blue-color filter 230B and the red-color filter 230R are overlapped in a plan view, most of the light can be blocked, thereby performing a role equivalent to a light blocking layer.

In the above, the embodiment in which the additional opening of the color filter located above is formed larger was explained.

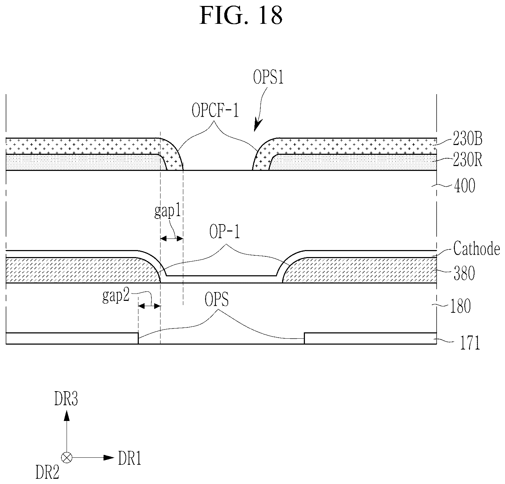

However, depending on the embodiment, the additional opening may be formed narrower while the color filter located above covers the color filter located below. This structure will be explained through the embodiment of FIG. 18.

According to FIG. 18, the blue-color filter 230B located at the top has a structure that covers the side or end of the red-color filter 230R located at the bottom.

As a result, the blue-color filter 230B has the narrowest additional opening, so that the additional opening of the blue-color filter 230B can correspond to the additional opening OPCF-1 of the plurality of color filters 230R and 230B.

The red-color filter 230R may have an additional opening larger than that of the blue-color filter 230B.

That is, an area of the additional opening of the color filter located at the top of the red-color filter 230R and the blue-color filter 230B may be smaller than an area of the additional opening of the color filter located at the bottom in a plan view.

In the embodiment FIG. 18, like the embodiment of FIG. 15B, the end of the cathode Cathode located on the inclined surface of the black pixel defining layer 380 is smaller than the ends of the blue-color filter 230B and the red-color filter 230R, the cathode Cathode located inside and on the inclined surface of the black pixel defining layer 380 has a structure that is obscured by the blue-color filter 230B and the red-color filter 230R in a plan view, which is shown in FIG. 20. For reference, if the blue-color filter 230B and the red-color filter 230R are overlapped in a plan view, most of the light can be blocked, thereby performing a role equivalent to a light blocking layer.

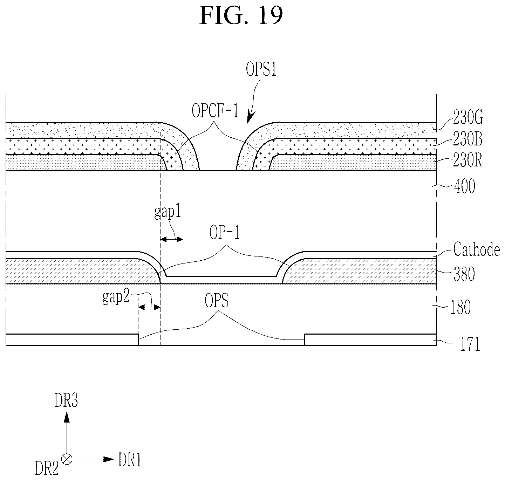

The embodiment of FIG. 18 shows a structure in which only two color filters are stacked, but depending on the embodiment, three or more color filters can be stacked, and an embodiment with three color filters is explained through FIG. 19.

The embodiment of FIG. 19 further includes the green-color filter 230G in addition to the embodiment of FIG. 18, where the green-color filter 230G covers the sides or ends of the bottom-positioned blue-color filter 230B and the red-color filter 230R.

As a result, the green-color filter 230G has the narrowest additional opening, so that the additional opening of the green-color filter 230G corresponds to the additional opening OPCF-1 of the plurality of color filters 230R, 230G, 230B.

The blue-color filter 230B may have an additional opening larger than the green-color filter 230G, and the red-color filter 230R may have an additional opening larger than the blue-color filter 230B.

That is, an area of the additional opening of the color filter located at the top may be smaller than an area of the additional opening of the color filter located at the bottom in a plan view.

In embodiment of FIG. 19, like the embodiment of FIG. 15B, the end of the cathode Cathode located on the inclined surface of the black pixel defining layer 380 is smaller than the ends of the blue-color filter 230B and the red-color filter 230R, the cathode Cathode located inside and on the inclined surface of the black pixel defining layer 380 has a structure that is obscured by the blue-color filter 230B and the red-color filter 230R in a plan view, which is shown in FIG. 20. For reference, if the blue-color filter 230B and the red-color filter 230R are overlapped in a plan view, most of the light can be blocked, thereby performing a role equivalent to a light blocking layer.

Additionally, in the embodiment of FIG. 19, unlike the embodiment of FIG. 18, the green-color filter 230G is located within the additional opening OP-1 of the black pixel defining layer 380. Referring to FIG. 20, the green-color filter has little effect on the color, especially the black color, and therefore can be located inside the end of the black pixel defining layer 380 in a plan view.

In FIG. 12 and FIG. 15B to FIG. 19, the first horizontal gap gap1 and the second horizontal gap gap2 may each have a value of 1 µm to 2 µm, and may have a different gap depending on the embodiment.

Hereinafter, FIG. 20 will show whether the role of the light blocking layer 220 can be replaced by stacking a plurality of color filters.

FIG. 20 is a graph showing the transmittance according to the wavelength of the color filter.

FIG. 20 is a graph of the transmittance for the wavelengths of each color filter 230R, 230G, 230B, so light in the wavelength range indicated at a high point passes through.

Referring to FIG. 20, each color filter 230R, 230G, 230B has a transmittance rate of less than 10% for parts other than the wavelength band that passes through it, and it can be confirmed that there is almost no wavelength band that is transmitted when three or two color filters overlap in a plan view.

Therefore, it can be confirmed that the role of the light blocking layer 220 can be replaced by overlapping a plurality of color filters in a plan view as shown in FIG. 15B to FIG. 18 above.

In the above, the planar structure of FIG. 11 was explained.

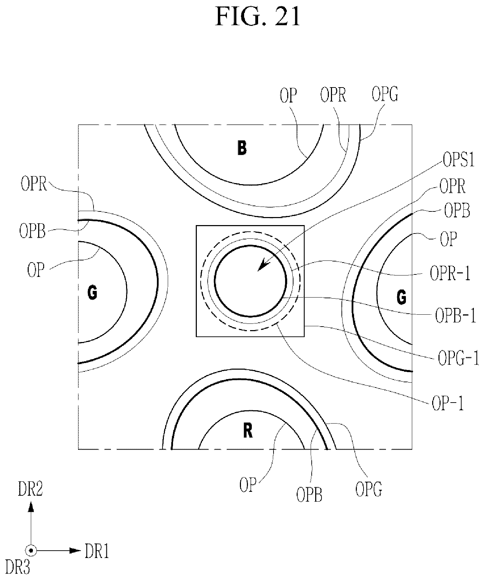

However, the planar structure may have a different structure from that of FIG. 11, and hereinafter, the first optical sensor area OPS1 having another planar structure will be looked at through FIG. 21.

FIG. 21 is a plan view of the first optical sensor area of the first component area according to another embodiment.

Since FIG. 21 is a plan view, the structure of each color filter 230R, 230G, 230B is not clearly shown, so reference numerals are assigned to each boundary line.

In addition, FIG. 21 shows the opening OP of the black pixel defining layer 380, which is located in and around the first optical sensor area OPS1 in the first component area EA1 and is a structure on the upper part of the light emitting diode that displays an image.

In FIG. 21, four openings OP of the black pixel defining layer 380 are shown, each having one light emitting layer displaying red (R), one light emitting layer displaying blue (B), and two light emitting layers displaying green (G).

Among the openings OP of the black pixel defining layer 380, the opening OPR of the red-color filter 230R and the opening OPB of the blue-color filter 230B are located above the portion corresponding to the green (G) light emitting layer, leaving only the green-color filter 230G.

Among the openings OP of the black pixel defining layer 380, the opening OPG of the green-color filter 230G and the opening OPB of the blue-color filter 230B are located above the portion corresponding to the red (R) light emitting layer, leaving only the red-color filter 230R.

In addition, the opening OPR of the red-color filter 230R and the opening OPR of the green-color filter 230G are located above the portion corresponding to the blue (B) light emitting layer among the openings OP of the black pixel defining layer 380. OPG is located, leaving only the blue-color filter 230B.

Meanwhile, an additional opening OP-1 of the black pixel defining layer 380 is located in the first optical sensor area OPS1, an additional opening OPG-1 of the green-color filter 230G is located above it, and an additional opening OPG-1 of the green-color filter 230G is located in the first optical sensor area OPS1, and the additional opening OPR-1 of the red-color filter 230R and the additional opening OPB-1 of the blue-color filter 230B are located so that light can pass therethrough without being blocked.

At this time, in the embodiment of FIG. 21, the additional opening OPB-1 of the blue-color filter 230B and the additional opening OPR-1 of the red-color filter 230R are added to the black pixel defining layer 380. It is formed narrower than the opening OP-1 in a cross-sectional view and has a structure in which a portion of the black pixel defining layer 380 is obscured by the blue-color filter 230B and the red-color filter 230R in a plan view, and is not visible from the front.

In FIG. 21, the additional opening OP-1 of the black pixel defining layer 380 is shown as a dotted line, indicating that it is obscured by the blue-color filter 230B and the red-color filter 230R in a plan view.

As a result, external light is not reflected from the cathode Cathode located on the inclined surface of the black pixel defining layer 380, so the location of the additional opening OPBM-1 of the light blocking layer 220 is not visible to the user's eyes.

In FIG. 21, an additional opening OP-1 of the black pixel defining layer 380, an additional opening OPB-1 of the blue-color filter 230B, and an additional opening OPB-1 of the red-color filter 230R, OPR-1 have a circular shape, and the additional opening OPG-1 of the green-color filter 230G has a square shape.

In other words, at least one of the additional openings OPR-1, OPG-1, OPB-1 located in each of the plurality of color filters 230R, 230G, 230B can have different planar shapes from each other, and the planar shape of the additional openings OPR-1, OPG-1, OPB-1 can be circular, elliptical, polygonal, or a combination of these shapes. As used herein, the "planar shape" is a shape in a plan view.

Meanwhile, depending on the embodiment, it may have a planar shape different from that of FIG. 21.

The additional openings OPR-1, OPG-1, OPB-1 of each color filter are formed larger than the additional openings OP-1 of the black pixel defining layer 380, so that the additional openings of the black pixel defining layer 380 can be formed so as not to block the light from the additional openings OP-1.

In addition, depending on the embodiment, the additional openings OPR-1, OPG-1, OPB-1 of each color filter are formed to be smaller than the additional openings OP-1 of the black pixel defining layer 380, it may be formed in a structure that blocks light from the additional opening OP-1 of the black pixel defining layer 380.

Between the opening OP of the black pixel defining layer 380 and the additional opening OP-1-that is, above the portion where the black pixel defining layer 380 is located-a plurality of color filters 230R, 230G, 230B are provided, and a plurality of color filters 230R, 230G, 230B may be located except for the portion where the openings OPR, OPG, OPB and additional openings OPR-1, OPG-1, OPB-1 are located.

The first component area EA1 including the first optical sensor area OPS1 in the various embodiments described above is surrounded by the display area DA, and the boundary between the first component area EA1 and the display area DA can be formed in various embodiments so that it is not recognized, which will be discussed below.

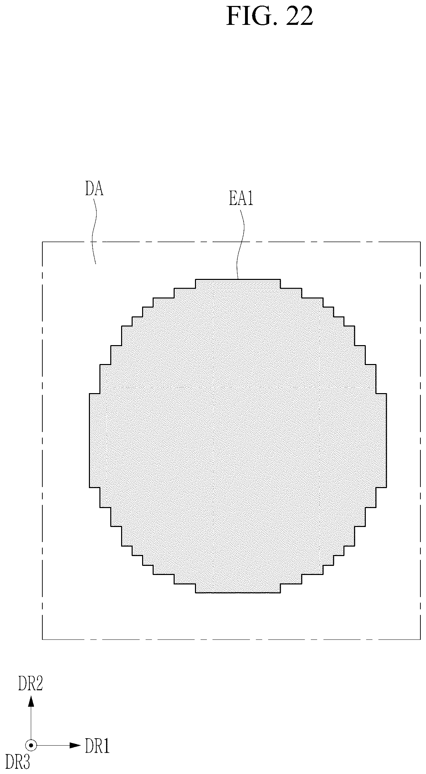

FIG. 22 to FIG. 24 are schematic plan views of a first component area according to an embodiment.

FIG. 22 to FIG. 24 schematically show the first component area EA1 and clearly show the boundary with the display area DA located around it.

The first optical sensor area OPS1 is located in the first component area EA1, and when the first optical sensor area OPS1 is visible, the display area DA and the display quality are recognized differently, and the first component area EA1 may be recognized by the user.

However, the light blocking layer or color filter is formed to have an additional opening narrower than the additional opening OP-1 of the black pixel defining layer 380 in a cross-sectional view, so the cathode Cathode on the black pixel defining layer 380 is not exposed and the first optical sensor area OPS1 is not easily visible.

As a result, as shown in FIG. 22, the first optical sensor area OPS1 may be formed in the first component area EA1 at a constant density and/or interval.

In other words, in FIG. 22, the first component area EA1 is marked with a certain hatching, which indirectly indicates that the density and/or spacing of the first optical sensor area OPS1 located in the first component area EA1 is constant.

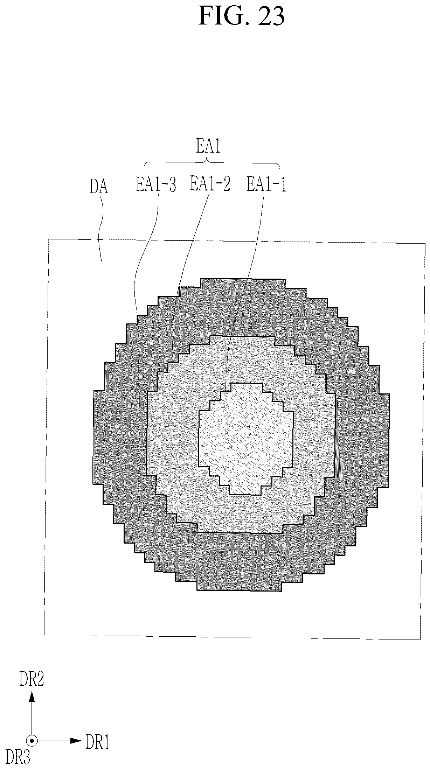

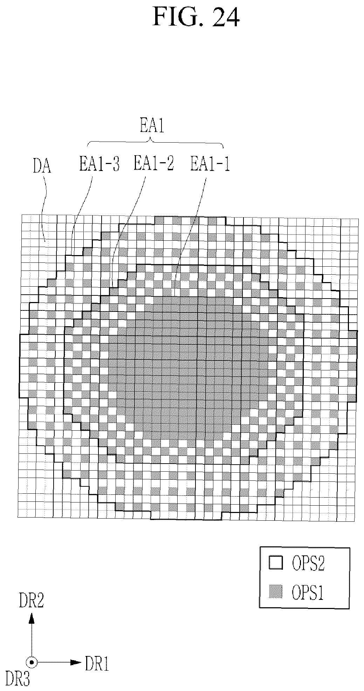

However, according to the embodiment, the boundary between the display area DA and the first component area EA1 can be formed by changing the density and/or spacing of the first optical sensor area OPS1 located in the first component area EA1 so that the user cannot recognize it well, which is explained through FIG. 23 and FIG. 24.

Referring to the embodiment of FIG. 23, one first component area EA1 is divided into three areas, labeled as a 1-1 component area EA1-1 and a 1-2 component area EA1-2, and a 1-3 component area EA1-3.

Here, the closer the component area is to the display area DA, the smaller the density and/or size of the first optical sensor area OPS1.

That is, the density and/or size of the first optical sensor area OPS1 of the 1-1 component area EA1-1 is the largest, the density and/or size of the first optical sensor area OPS1 of the 1-2 component area EA1-2 may have a medium value, and the density and/or size of the first optical sensor area OPS1 of the 1-3 component area EA1-3 may have the smallest value of the 1-1 component area EA1-1 to the 1-3 component area EA1-3.

In FIG. 23, the same color indicates the same density and/or size of the first optical sensor area OPS1, and the darker the color, the smaller the density and/or size of the first optical sensor area OPS1, indicating a smaller area of penetration.

FIG. 24 is a diagram showing the structure of FIG. 23 in more detail.

In FIG. 24, the part where the first optical sensor area OPS1 and the part where the second optical sensor area OPS2 are located in each component area are shown divided by color.

Here, the first optical sensor area OPS1 and the second optical sensor area OPS2 are the first optical sensor area (OPS1; transmissive optical sensor area) and the second optical sensor area (OPS2; non-transmissive optical sensor area), as shown in FIG. 10.

In the embodiment of FIG. 24, only the first optical sensor area OPS1 is located in the 1-1 component area EA1-1 (hereinafter referred to as "1 cycle"), and the second optical sensor area OPS2 is not located, and in the 1-2 component area EA1-2, the first optical sensor area OPS1 and the second optical sensor area OPS2 are located half and half (hereinafter referred to as "1/2 cycle"). In the 1-3 component area EA1-3, the first optical sensor area OPS1-3 the first optical sensor area OPS1 is located one in every four (hereinafter referred to as "1/4 cycle"), and the remaining three are located in the second optical sensor area OPS2.

FIG. 24 illustrates an example of implementation, and although it can be arranged in a different number, as it gets closer to the display area DA, the density of the first optical sensor area OPS1 decreases and the density of the second optical sensor area OPS2 increases.

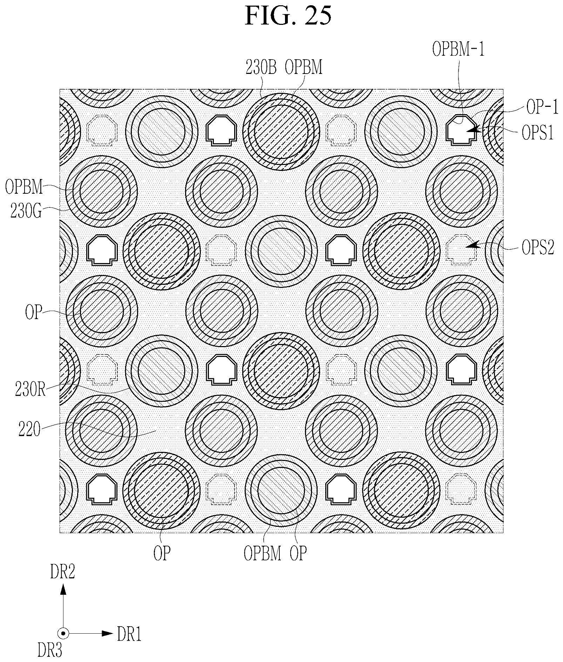

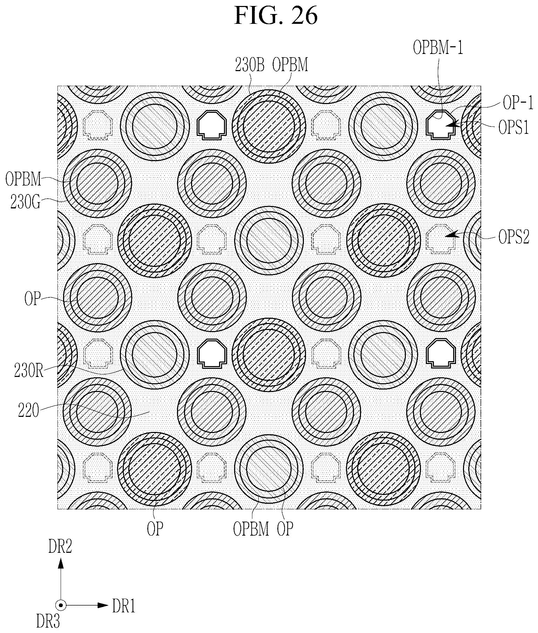

The structure of FIG. 24 simply uses a square to show the presence of a first optical sensor area OPS1 and a second optical sensor area OPS2. This will be explained in more detail through FIG. 25 and FIG. 26.

FIG. 25 and FIG. 26 are plan views of the first component area according to an embodiment.

In FIG. 25, the first optical sensor area OPS1 is shown as a component area formed in "1/2 cycle," corresponding to the 1-2 component area EA1-2 of FIG. 24, in FIG. 26, the first optical sensor area OPS1 is shown as a component area formed in "1/4 cycle," corresponding to the 1-3 component area EA1-3 of FIG. 24.

FIG. 25 and FIG. 26 show the planar positional relationship of the black pixel defining layer 380, the light blocking layer 220, and the color filter 230 in the first component area.

Meanwhile, depending on the embodiment, a pixel defining layer formed of a highly transparent material may be used instead of the black pixel defining layer 380.

Here, as materials with high transparency, general-purpose polymers such as polystyrene PS or imide-based polymers such as polyimide PI can be used. In addition, polymethylmethacrylate PMMA, polymer derivatives with phenolic groups, and acrylic-based polymers can be used, and may include organic insulating materials such as polymers, acrylic polymers, and siloxane polymers.

Specifically, the light blocking layer 220 includes an opening OPBM, and the opening OPBM may be formed to be wider while overlapping the opening OP of the black pixel defining layer 380 in a plan view.

Color filters 230R, 230G, and 230B are positioned on the light blocking layer 220.

The color filters 230R, 230G, and 230B have a structure that fills the opening OPBM of the light blocking layer 220, and may be formed to be wider than the opening OPBM of the light blocking layer 220 in a plan view.

In FIG. 25 and FIG. 26, each color filter is shown with different hatching so that it can be easily distinguished.

Below, the upper structure in the secondary optical sensor area OPS of the first component area EA1 will be explained.

First, the upper structure of the first optical sensor area (OPS1; transmission-type optical sensor area) through which light passes may be as follows.

In the first optical sensor area OPS1, an additional opening OP-1 is formed in the black pixel defining layer 380 corresponding to the secondary optical sensor area OPS, and an additional opening OPBM-1 is formed in the light blocking layer 220.

As a result, there is no light blocking structure in the first optical sensor area OPS1 due to the additional opening OPBM-1 of the light blocking layer 220 and the additional opening OP-1 of the black pixel defining layer 380.

As a result, even if sensors (including optical sensors, infrared sensors, etc.) are placed on the back of the light emitting display panel DP, the front of the light emitting display panel DP can be sensed with light.

In FIG. 25 and FIG. 26, the first optical sensor area OPS1 is shown in white because light can pass through the first optical sensor area OPS1.

Meanwhile, the upper structure of the second optical sensor area (OPS2; non-transmissive optical sensor area) through which light does not pass may be as follows.

In the second optical sensor area OPS2, there is no additional opening OP-1 located on the black pixel defining layer 380 corresponding to the second optical sensor area OPS, and no additional opening OPBM-1 is formed on the light blocking layer 220. Therefore, it has a structure in which light is blocked by the black pixel defining layer 380 and/or the light blocking layer 220.

In FIG. 25 and FIG. 26, additional openings OP-1, OPBM-1 located in the second optical sensor area OPS2 are only indicated by dotted lines because they are not located, and because the light blocking layer 220 is located, it is marked in a color other than white.

As a result, the secondary optical sensor area OPS in the first component area EA1 is not used for sensor operation and can be used to adjust reflectance or reflected color.

That is, when external light is incident on the first component area EA1, some of the light is reflected. In order to configure the first component area EA1 to correspond to the reflectance or reflected color of the display area DA, the first optical sensor is used, and the number and arrangement of the first optical sensor area OPS1 and the second optical sensor area OPS2 are adjusted.

As a result, the sensor located on the back of the first component area EA1 is able to detect the front of the light emitting display device, and additionally the color of light reflection in the first component area EA1 is improved, and the display area DA and the first component area EA1 may be similar in terms of reflectance or reflection color reduction.

As a result, the user cannot distinguish between the display area DA and the first component area EA1.

In FIG. 25 and FIG. 26, the color filters 230R, 230G, and 230B are located only in areas corresponding to the opening OP of the black pixel defining layer 380 and the opening OPBM of the light blocking layer 220.

As a result, in the embodiments of FIG. 25 and FIG. 26, the color filters 230R, 230G, and 230B have a circular shape corresponding to the shape of the opening OP of the black pixel defining layer 380 and the opening OPBM of the light blocking layer 220.

However, depending on the embodiment, the color filters 230R, 230G, and 230B may have various shapes and may have shapes that do not correspond to the shapes of the opening OP of the black pixel defining layer 380 and the opening OPBM of the light blocking layer 220.

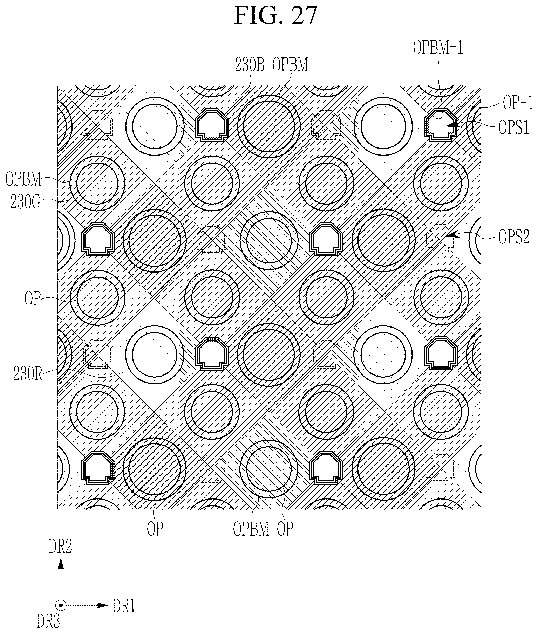

Below, the planar shape of color filters 230R, 230G, and 230B having another structure will be explained through FIG. 27.

FIG. 27 is a plan view of a first component area according to another embodiment.

FIG. 27 is a modified view of FIG. 25 in which the color filters 230R, 230G, and 230B have a planar shape corresponding to a diamond shape.

Specifically, each of the color filters 230R, 230G, and 230B has a diamond shape covering the opening OP of the corresponding black pixel defining layer 380 and the opening OPBM of the light blocking layer 220.

Each of the color filters 230R, 230G, 230B does not cover the first optical sensor area OPS1, so the boundaries of each of the color filters 230R, 230G, 230B can be located along the border of the first optical sensor area OPS1.

At this time, the boundary between the first optical sensor area OPS1 and the color filters 230R, 230G, and 230B may have the same structure as one of the embodiments of FIG. 15B to FIG. 18.

Meanwhile, at least one of the color filters 230R, 230G, and 230B may have a structure that covers the second optical sensor area OPS2.

In FIG. 27, the boundary between the adjacent color filters 230R, 230G, and 230B is shown as a single line, and the adjacent color filters 230R, 230G, and 230B are shown in a structure in contact with each other. However, depending on the embodiment, the adjacent color filters 230R, 230G, and 230B are shown as a single line, and the color filters 230R, 230G, and 230B may have a structure formed while at least partially overlapping each other in a plan view.

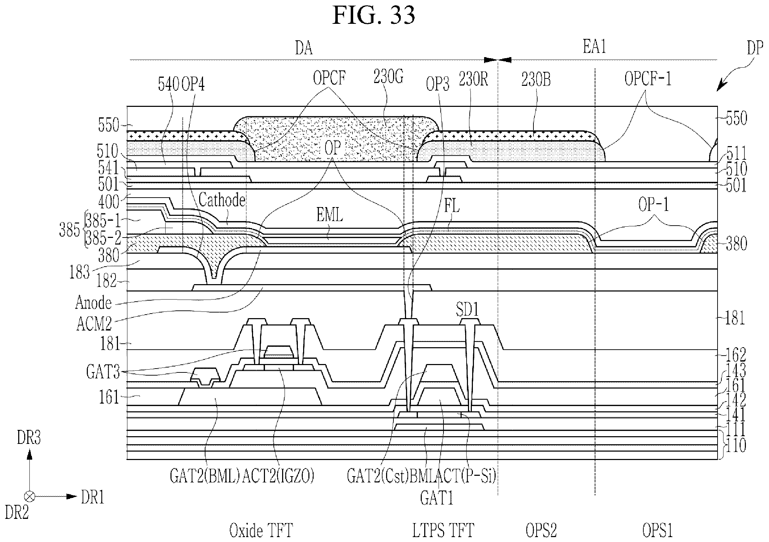

Additionally, depending on the embodiment, it may have a structure (see FIG. 33) in which at least two color filters 230R, 230G, and 230B overlap in a plan view, instead of the light blocking layer 220.

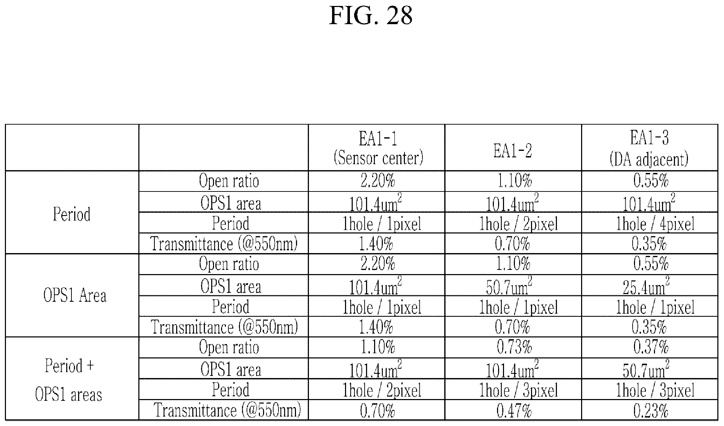

Hereinafter, various embodiments of the first component area EA1 according to the embodiments of FIG. 23 and FIG. 24 will be looked at in a table through FIG. 28.

FIG. 28 is a table classifying the structure of the first component area according to an embodiment.

Referring to FIG. 28, not only the embodiment of changing the period of the first optical sensor area OPS1 in each of the three component areas EA1-1, EA1-2, EA1-3, but also the first optical sensor area OPS1, or an example of changing the period and area together is also described.

In FIG. 28, "Open ratio" represents the ratio of the area through which light can pass to the entire area of the first component area EA1, and "OPS1 area" represents the area of one first optical sensor area OPS1, the period refers to the period of the first optical sensor area OPS1, and the transmittance indicates the light transmittance at which a light with a wavelength of 550 nm is transmitted through the first optical sensor area OPS1 in the first component area EA1.

Referring to FIG. 28, the embodiment of changing the period is an embodiment in which the "OPS1 area" is constant, but the "Open ratio" and transmittance of the three component areas are adjusted by varying the period.

Meanwhile, the embodiment of changing the "OPS1 area" is an embodiment of adjusting the "Open ratio" and transmittance of the three component areas using the "OPS1 area" even though the period of the first optical sensor area OPS1 is constant.

Meanwhile, in an embodiment in which the period and the "OPS1 area" are combined and applied, the "Open ratio" and transmittance of the three component areas are adjusted while changing both the "OPS1 area" and the period.

In the embodiment of merging the period and the "OPS1 area" in FIG. 28, the 1-1 component area EA1-1 and the 1-2 component area EA1-2 have the same "OPS1 area," but the period is changed, the "Open ratio" and transmittance are adjusted, and the 1-2 component area EA1-2 and the 1-3 component area EA1-3 have the same period, but the "OPS1 area" is changed to change the "Open ratio" and transmittance.

However, various embodiments may be applied differently.

Depending on the embodiment, the number, period, and location of the first optical sensor area OPS1 may be formed in various ways.

In addition, since it is determined whether the sensor located on the back of the first component area EA1 can detect the front surface depending on the first optical sensor area OPS1, the first optical sensor is configured to have the necessary transmittance for operation of the sensor, the minimum number, arrangement, etc. of the first optical sensor area OPS1 may be determined.

In this embodiment, the secondary optical sensor area OPS is formed adjacent to all pixel circuit parts located in the first component area EA1, and the number of first optical sensor areas OPS1 is in the first component area EA1, the number may be equal to or smaller than the number of second optical sensor areas OPS2.

That is, the first component area EA1 has a 1/2 cycle in which one second optical sensor area OPS2 is formed for one first optical sensor area OPS1, as shown in FIG. 13, or it has a 1/4 cycle in which three second optical sensor areas OPS2 are formed for one first optical sensor area OPS1, or it has a 3/8 cycle in which five second optical sensor areas OPS2 are formed for three first optical sensor areas OPS1, or it has a 1/8 cycle in which seven second optical sensor areas OPS2 are formed for one first optical sensor area OPS1. Alternatively, it may have a 1/9 cycle in which eight second optical sensor areas OPS2 are formed for one first optical sensor area OPS1.

In various embodiments such as FIG. 28, as shown in FIG. 11, FIG. 12, and FIG. 15B to FIG. 18, the cathode Cathode located on the upper part of the black pixel defining layer 380 covered by a light blocking layer 220 or at least one color filter and has a structure that prevents external light from being reflected.

In the above, the structure of the first component area EA1 has been explained, and according to the embodiment, such arrangement of the first optical sensor area OPS1 and the second optical sensor area OPS2 can also be applied in the second component area EA2.

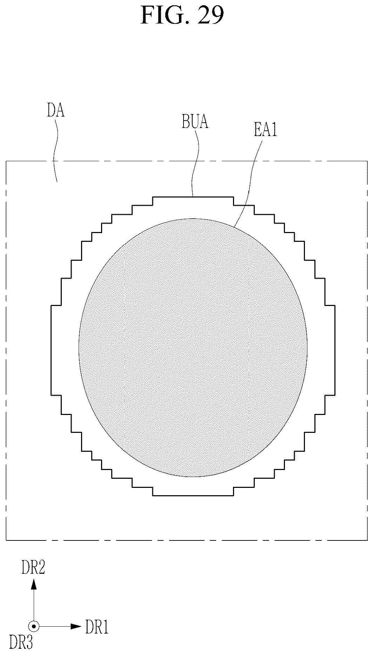

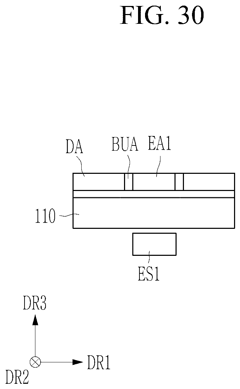

Meanwhile, depending on the embodiment, a separate buffer area BUA is formed between the first component area EA1 and the display area DA to prevent recognition of the boundary between the first component area EA1 and the display area DA, and such an embodiment will be explained through FIG. 29 and FIG. 30.

FIG. 29 is a schematic plan view of a first component area and its surrounding area according to another embodiment, and FIG. 30 is a schematic cross-sectional view of the first component area and its surrounding area of FIG. 29.

Referring to FIG. 29, the buffer area BUA is located between the first component area EA1 and the display area DA.

In FIG. 29, the first component area EA1 is shown as a circle, but may have a structure including a curved straight line like the buffer area BUA.

Here, the buffer area BUA may have a value between the period value or area value of the first optical sensor area OPS1 or the second optical sensor area OPS2 compared to the first component area EA1 and the display area DA, and may be an area with an intermediate value in both the period value and the area value, depending on the embodiment.

Referring to FIG. 30, a schematic cross-sectional structure of the light emitting display device according to the embodiment of FIG. 29 is shown, and the lower structure of the light emitting display device is schematically shown by only showing the substrate 110.

Referring to FIG. 30, the first optical element ES1 is located on the backside of the first component area EA1, and through the first optical sensor area OPS1 located in the first component area EA1, it can detect the front of the light emitting display device.

The buffer area BUA is located between the first component area EA1 and the display area DA.

Here, in order to prevent the user from recognizing the boundary between the first component area EA1 and the display area DA, the buffer area BUA uses the reflectance or reflection color of the display area DA and that of the first component area EA1, and it may be an area formed to have an intermediate value of reflectance or reflected color.

Depending on the embodiment, an additional opening may be positioned to have a similar structure to the first optical sensor area OPS1 described above, and the period or area of the additional opening may be smaller than that of the first component area EA1.

As a result, the user cannot easily recognize the boundary between the first component area EA1 and the display area DA, and cannot distinguish the display area DA from the first component area EA1.

In the following, whether the first component area is visible through a specifically simulated photo focusing on the embodiment of FIG. 15B described above will be explained.

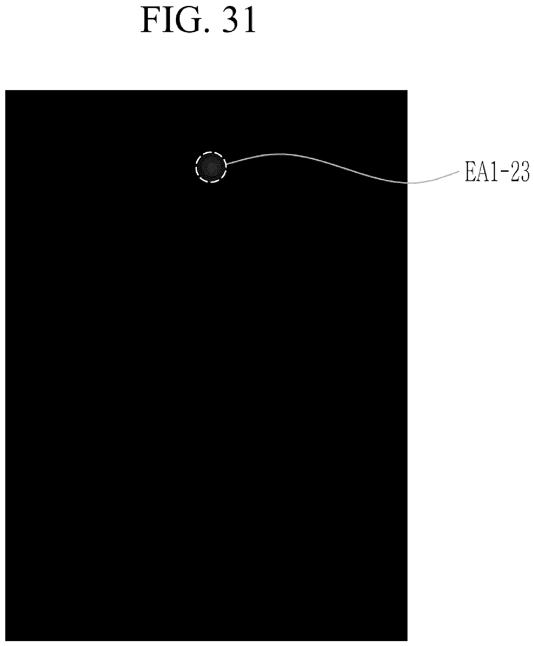

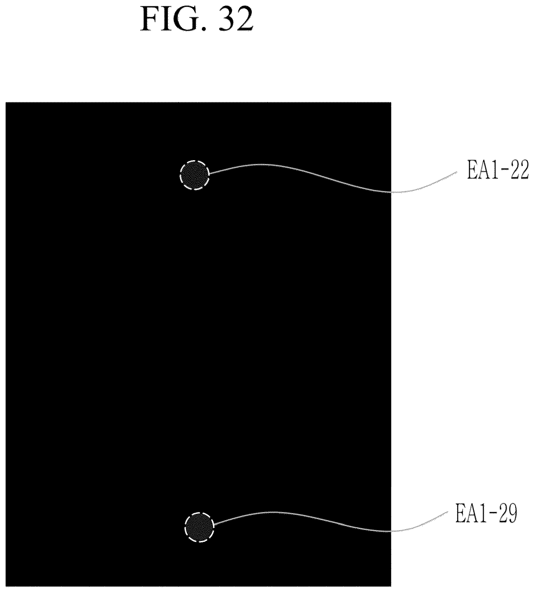

FIG. 31 and FIG. 32 are photographs of the first component area according to an embodiment.

The first component area EA1-23 shown in FIG. 31 is divided into three areas as shown in FIG. 23, and of the two first component areas shown in FIG. 32, the first component area EA1-22 is an area formed by dividing into one area as shown in FIG. 22, and the first component area EA1-29 is an area formed including a buffer area as shown in FIG. 29.

To show the effect, each of the first component areas EA1-23, EA1-22, EA1-29 is indicated with a leader line in FIG. 31 and FIG. 32, but if there is no separate leader line, the location cannot be easily confirmed.

Therefore, when the cathode Cathode located on the black pixel defining layer is obscured by a light blocking layer or a color filter in a plan view, it can be confirmed that the first component area EA1 is difficult for the user to see.

Hereinafter, with reference to FIG. 33, unlike FIG. 10, an embodiment in which the color filters 230R, 230G, and 230B are formed by overlapping each other in a plan view and does not include the light blocking layer 220 will be described.

FIG. 33 is a cross-sectional view of a display panel of a light emitting display device according to another embodiment.

The structure from FIG. 33 of the third sensing insulating layer 511 is the same as that of FIG. 10.

Accordingly, description of the structure up to the third sensing insulating layer 511 will be omitted.

Color filters 230R, 230G, and 230B are located on the third sensing insulating layer 511.

In the embodiment of FIG. 33, there is no inclusion of a light blocking layer, and the role of the light blocking layer is performed by the overlapped color filters 230R and 230B, which can be positioned to overlap the color filters 230R and 230B with the sensing electrodes 540 and 541 in a plan view.

The overlapping color filters 230R and 230B define an opening OPCF therein, and the opening OPCF of the overlapping color filters 230R and 230B overlaps the opening OP of the black pixel defining layer 380 in a plan view.

Additionally, the opening OPCF of the overlapping color filters 230R and 230B in a plan view may be wider than the opening OP of the black pixel defining layer 380 in a cross-sectional view.

As a result, the anode Anode that overlaps the opening OP of the black pixel defining layer 380 (i.e., exposed by the opening OP of the black pixel defining layer 380) also overlaps the color filters 230R and 230B in a plan view, so it is possible to have a structure that is not obscured in a plan view.

This is to ensure that the anode Anode and the light emitting layer EML capable of displaying an image are not obscured by the overlapping color filters 230R and 230B and the sensing electrodes 540 and 541 in a plan view.

Also, the stacked color filters 230R and 230B have a structure that overlaps the anode connection opening OP4 and the second lower organic layer opening OP3C, but does not overlap the first lower organic layer opening OP3U in a plan view.

A green-color filter 230G of a different color may be located within the opening OPCF of the overlapping color filters 230R and 230B.

Depending on the embodiment, the color filters 230R, 230G, and 230B may be replaced with a color conversion layer or may further include a color conversion layer.

The color conversion layer may include quantum dots.

The planarization layer 550 covering the color filters 230R, 230G, and 230B is positioned on the color filters 230R, 230G, and 230B.

The planarization layer 550 is used to planarize the upper surface of the light emitting display device, and may be a transparent organic insulating layer containing one or more materials selected from the group consisting of polyimide, polyamide, acrylic resin, benzocyclobutene, and phenol resin.

Depending on the embodiment, a low refractive layer and an additional planarization layer may be further positioned on the planarization layer 550 to improve front visibility and light output efficiency of the display device.

Light can be refracted and emitted toward the front by the low refractive layer and an additional planarization layer with high refractive characteristics.

In this case, depending on the embodiment, the planarization layer 550 may be omitted and the low refractive layer and the additional planarization layer may be located directly on the color filter 230.

In this embodiment, a polarizer is not included on top of the planarization layer 550.

In other words, the polarizer can play a role in preventing display quality from deteriorating when external light is incident and reflected by an anode, etc., and is visible to the user.

However, in this embodiment, the side of the anode Anode is covered with the black pixel defining layer 380 to reduce the degree of reflection from the anode Anode, and overlapping color filters 230R and 230B are also formed to reduce the degree of incident light to prevent deterioration of display quality due to reflection.

Therefore, there is no need to separately form the polarizer on the front of the display panel DP.

Also, in this embodiment, the anode Anode, which is exposed through the opening OP of the black pixel defining layer 380, which is a part where external light can be reflected, is formed flatly so that light does not reflect asymmetrically from the anode Anode.

In addition, the part of the anode connection opening OP4, which is the most uneven of the anodes Anode, is covered by the black pixel defining layer 380 and the overlapping color filters 230R and 230B to prevent light from being reflected asymmetrically.

Meanwhile, FIG. 33 shows, in addition to the stacked structure of the display area DA, a stacked structure of the optical sensor area OPS that is formed to allow light to pass through a portion of the display area DA.

In the embodiment of FIG. 33, some of the secondary optical sensor areas OPS are covered with overlapping color filters 230R and 230B, and some are not covered by the color filters by the additional openings OPCF-1 located in the overlapping color filters 230R and 230B.

Here, the secondary optical sensor area OPS covered with the overlapping color filters 230R, 230B corresponds to the second optical sensor area OPS2, and the secondary optical sensor area not covered by the overlapping color filters 230R, 230B the optical sensor area OPS corresponds to the first optical sensor area OPS1.

For reference, the secondary optical sensor area OPS consists of only a transparent layer so that light can pass therethrough, and there is no conductive layer or semiconductor layer, and the black pixel defining layer 380, light blocking layer, and color filter 230 are an opening (hereinafter referred to as an additional opening) formed at a position corresponding to the optical sensor area OPS, so that it does not block light.

Specifically, the buffer layer 111, which is an inorganic insulating layer, is positioned on the substrate 110, and the first gate insulating layer 141 and the second gate insulating layer 142, which are inorganic insulating layers, are sequentially positioned thereon.

Additionally, the first interlayer-insulating layer 161, a third gate insulating layer 143, and the second interlayer-insulating layer 162, which are inorganic insulating layers, are sequentially stacked on the second gate insulating layer 142.

On the second interlayer-insulating layer 162, the first organic layer 181, the second organic layer 182, and the third organic layer 183, which are organic insulating layers, are sequentially stacked.

The functional layer FL may be located on the third organic layer 183, and a cathode Cathode may be located on the third organic layer 183.

The encapsulation layer 400 is positioned on the cathode Cathode, and sensing insulating layers 501, 510, and 511 are sequentially positioned on top of the cathode Cathode.

The encapsulation layer 400 may have a triple-layer structure sequentially including an inorganic encapsulation layer, an organic encapsulation layer, and an inorganic encapsulation layer.

Additionally, the sensing insulating layers 501, 510, and 511 may all be inorganic insulating layers.

The planarization layer 550 may be positioned on the sensing insulating layers 501, 510, and 511.

A metal layer, a first semiconductor layer, a first gate conductive layer, a second gate conductive layer, an oxide semiconductor layer, a third gate conductive layer, a first data conductive layer, and a second data conductive layer, and an anode are not located in the above secondary optical sensor area OPS.

Additionally, the light emitting layer EML and the sensing electrodes 540 and 541 are not formed.

Additionally, in the optical sensor area OPS, additional openings are formed in the black pixel defining layer 380, the light blocking layer, and the color filter 230, so the black pixel defining layer 380, the light blocking layer, and the color filter 230 may not be formed.

In the above, an embodiment has been explained in which a total of three organic layers are formed, and an anode connection opening is formed in the second organic layer and the third organic layer.

However, at least two organic layers may be formed, and in this case, the anode connection opening may be located in the upper organic layer located away from the substrate, and the lower organic layer opening may be located in the lower organic layer.

Below, an embodiment will be explained in which a transparent pixel defining layer is used instead of a black pixel defining layer through FIG. 34.

FIG. 34 is a cross-sectional view of a display panel of a light emitting display device according to still another embodiment.

FIG. 34 is a diagram corresponding to FIG. 10, and is an example in which a transparent pixel defining layer 381 is used instead of a black pixel defining layer.

In order to illustrate the use of the transparent pixel defining layer 381, the transparent pixel defining layer 381 is shown without hatching in FIG. 34.

The difference between the embodiment of FIG. 34 and the embodiment of FIG. 10 will be explained as follows.

The transparent pixel defining layer 381 is a pixel defining layer formed of a high transparency material, and general-purpose polymers such as polystyrene PS or imide-based polymers such as polyimide PI can be used. In addition, organic insulating materials such as polymethylmethacrylate PMMA or polymer derivatives with a phenolic group, acrylic polymers, acrylic polymers, siloxane polymers, etc. may be included.

Since the transparent pixel defining layer 381 is used instead of the black pixel defining layer, the transparent pixel defining layer 381 does not have an opening in the first optical sensor area OPS1 and the second optical sensor area OPS2, and the transparent pixel defining layer 381 may overlap the first optical sensor area OPS1 and the second optical sensor area OPS2 in a plan view.

Specifically, in this embodiment, the light blocking layer 220 and/or the transparent pixel defining layer 381 are located on the front of the secondary optical sensor area OPS located between adjacent pixel circuit units. The light blocking layer 220 has an additional opening OPBM-1 that overlaps with the first optical sensor area OPS1 of the secondary optical sensor area OPS in a plan view, but the light blocking layer 220 does not have an additional opening OPBM-1 that overlaps with the second optical sensor area OPS2 of the secondary optical sensor area OPS in a plan view. On the other hand, since the transparent pixel defining layer 381 has high transparency, no opening is formed in the first optical sensor area OPS1 of the secondary optical sensor area OPS and the second optical sensor area OPS2 of the secondary optical sensor area OPS, and the transparent pixel defining layer 381 and the secondary optical sensor area OPS may have a structure in which they overlap each other in a plan view.

Although the embodiments have been described in detail bove, the scope of the present invention is not limited thereto, and various modifications and improvements made by those skilled in the art using the basic concepts of the present invention defined in the following claims are also possible.

**<Description of symbols>**

| | | | |
|---|---|---|---|
| 1000: | display device | DP: | display panel |
| DA, DA1-1, DA1-2: | display area | EA: | component area |
| EA1, EA1-1, EA1-2, EA1-3: | first component area | | |
| EA2: | second component area | ES, ES1, ES2: | optical elements |
| OPS: | secondary optical sensor area | OPS1: | first optical sensor area |
| OPS2: | second optical sensor area | BUA: | buffer area |
| 380: | black pixel defining layer | | |
| OP: | opening of black pixel defining layer | | |
| OP-1: | additional opening of black pixel defining layer | | |
| 220: | light blocking layer | OPBM: | opening of light blocking layer |
| OPBM-1: | additional opening of light blocking layer | | |
| 230, 230R, 230G, 230B: | color filter | | |
| OPR, OPG, OPB: | opening of color filter | | |
| OPCF-1, OPR-1, OPG-1, OPB-1: | additional opening of color filter | | |
| 110: | substrate | 171: | data line |
| 180, 181, 182, 183: | organic layer | OP1, OP2, OP3, OP4: | opening |
| 385: | spacer | 400: | encapsulation layer |
| Anode: | anode | Cathode: | cathode |
| EML: | light emitting layer | FL: | functional layer |
| T1, T2, T3, T4, T5, T6, T7: | transistor | | |
| Cst: | storage capacitor | Cboost: | boost capacitor |
| FA: | folding area | FAX: | folding axis |

## Claims

1. A light emitting display device (1000), comprising:
a display panel (DP) including a display area (DA) and a component area (EA), wherein the component area is surrounded by the display area and includes a plurality of optical sensor areas; and
an optical element (ES) located under the display panel (DP) and on a back surface of the component area,
wherein the display area includes
an anode and a cathode,
a pixel defining layer defining an opening (OP) that overlaps the anode in a plan view;
the cathode covering the pixel defining layer;
an encapsulation layer (400) located on a top of the cathode; and
a color filter (230B, 230G, 230R) located on the encapsulation layer and overlapping the opening (OP) of the pixel defining layer in the plan view,
wherein each of the color filter (230B, 230G, 230R) and the pixel defining layer extends to the component area and defines an additional opening (OP-1, OPCF-1) therein corresponding to each optical sensor area of the plurality of optical sensor areas, and
wherein an area of the additional opening (OPCF-1) of the color filter (230B, 230G, 230R) is smaller than an area of the additional opening (OP-1) of the pixel defining layer in the plan view such that a portion of the pixel defining layer is obscured by the color filter (230B, 230G, 230R) in the plan view in each of the optical sensor areas.

2. The light emitting display device (1000) of claim 1, wherein:
a portion of the cathode located on an inclined surface of the pixel defining layer in each of the optical sensor areas is obscured by the color filter (230B, 230G, 230R) in the plan view.

3. The light emitting display device (1000) of claim 1 or 2, wherein:
an interval between the additional opening (OP-1) of the pixel defining layer and the additional opening (OPCF-1) of the color filter (230B, 230G, 230R) is 1 µm to 2 µm, and/or wherein:
the pixel defining layer is a black pixel defining layer (380), and a light blocking layer is not located on an upper portion of the black pixel defining layer.

4. The light emitting display device (1000) of any of the preceding claims, wherein:
the color filter (230B, 230G, 230R) includes a red-color filter (230R) and a blue-color filter (230B),
the red-color filter (230R) and the blue-color filter (230B) each defines an additional opening (OPR-1, OPB-1) therein, and
an area of the additional opening (OPR-1, OPB-1) of a lower positioned color filter of the red-color filter (230R) and the blue-color filter (230B) is smaller than an area of the additional opening (OPR-1, OPB-1) of an upper positioned color filter of the red-color filter (230R) and the blue-color filter (230B) in the plan view.

5. The light emitting display device (1000) of any of the preceding claims, wherein:
the color filter (230B, 230G, 230R) includes a red-color filter (230R) and a blue-color filter (230B),
the red-color filter (230R) and the blue-color filter (230B) each defines an additional opening (OPR-1, OPB-1) therein, and
an upper positioned color filterof the red-color filter (230R) and the blue-color filter (230B) covers a side of alower positioned color filter of the red-color filter (230R) and the blue-color filter (230B).

6. The light emitting display device (1000) of claim 5, wherein:
an area of the additional opening (OPR-1, OPB-1) of the upper positioned color filter of the red-color filter (230R) and the blue-color filter (230B) is smaller than an area of the additional opening (OPR-1, OPB-1) of the lower positioned color filter of the red-color filter (230R) and the blue-color filter (230B) in the plan view.

7. The light emitting display device (1000) of any of claims 1 to 3, wherein:
the color filter (230B, 230G, 230R) includes a red-color filter (230R), a green-color filter (230G), and a blue-color filter (230B),
the red-color filter (230R), the green-color filter (230G), and the blue-color filter (230B) each defines an additional opening (OPR-1, OPG-1, OPB-1) therein,
an area of the additional opening (OPR-1, OPG-1, or OPB-1) of a lowermost positioned color filteramong the red-color filter (230R), the green-color filter (230G), and the blue-color filter (230B) is the smallest among the additional openings (OPR-1, OPG-1, OPB-1) of the red-color filter (230R), the green-color filter (230G), and the blue-color filter (230B), and an area of the additional opening (OPR-1, OPG-1, or OPB-1) of an uppermost positioned color filteramong the red-color filter (230R), the green-color filter (230G), and the blue-color filter (230B) is the largest among the additional openings (OPR-1, OPG-1, or OPB-1) of the red-color filter (230R), the green-color filter (230G), and the blue-color filter (230B), and/or, wherein:
the color filter (230B, 230G, 230R) includes a red-color filter (230R), a green-color filter (230G), and a blue-color filter (230B),
the red-color filter (230R), the green-color filter (230G), and the blue-color filter (230B) each defines an additional opening (OPR-1, OPG-1, OPB-1) therein,
at least two of the additional openings (OPR-1, OPG-1, OPB-1) of the red-color filter (230R), the green-color filter (230G), and the blue-color filter (230B) have different shapes from each other in the plan view.

8. The light emitting display device (1000) of any of the preceding claims, wherein:
the component area (EA) is divided into a plurality of component areas, and
a component area among the plurality of component areas located close to the display area has a smaller density or size of a corresponding optical sensor area than a component area among the plurality of component areas located relatively far from the display area.

9. The light emitting display device (1000) of claim 8, wherein:
the component area has a 1-1 component area, a 1-2 component area, and a 1-3 component area,
the 1-3 component area is located closest to the display area, and the 1-1 component area is located furthest from the display area, and
the density or size of the optical sensor area of the 1-1 component area is the largest, the density or size of the optical sensor area of the 1-2 component area has an intermediate value, and the density or size of the optical sensor area of the 1-3 component area has the smallest among the densities or sizes of the optical sensor areas of the 1-1 component area to 1-3 component area.

10. The light emitting display device (1000) of any of the preceding claims, wherein:
a buffer area (BUA) is located between the component area (EA) and the display area (DA).

11. A light emitting display device (1000), comprising:
a display panel including a display area (DA) and a component area (EA), wherein the component area is surrounded by the display area and includes a plurality of optical sensor areas; and
an optical element located on a back surface of the component area,
wherein the display area includes
an anode and a cathode,
a pixel defining layer defining an opening (OP) that overlaps the anode in a plan view;
the cathode covering the pixel defining layer;
an encapsulation layer located on a top of the cathode; and
a light blocking layer (220) positioned on the encapsulation layer and defining an opening (OPBM) that overlaps the opening (OP) of the pixel defining layer in the plan view,
wherein each of the light blocking layer and the pixel defining layer each extends to the component area and defines an additional opening (OP-1, OPBM-1) therein corresponding to each optical sensor area of the plurality of optical sensor areas, and
wherein an area of the additional opening (OPBM-1) of the light blocking layer is smaller than an area of the additional opening (OP-1) of the pixel defining layer in the plan view such that a portion the pixel defining layer is obscured by the light blocking layer in the plan view in the each optical sensor area.

12. The light emitting display device (1000) of claim 11, wherein:
a portion of the cathode located on an inclined surface of the pixel defining layer in each of the optical sensor areas is obscured by the light blocking layer in the plan view, and/or wherein:
a gap between the additional opening (OP-1) of the pixel defining layer and the additional opening (OPBM-1) of the light blocking layer is 1 µm to 2 µm.

13. The light emitting display device (1000) of claim 11 or 12, wherein:
the display area is located on the encapsulation layer and further includes a plurality of color filters (230B, 230G, 230R) located in the opening (OPBM) of the light blocking layer, and/or wherein:
the color filter (230B, 230G, 230R) is not located in each of the optical sensor areas.

14. The light emitting display device (1000) of any of claims 11 to 13, wherein:
the component area (EA) is divided into a plurality of component areas, and
a component area among the plurality of component areas located close to the display area has a smaller density or size of a corresponding optical sensor area than a component area among the plurality of component areas located relatively far from the display area, and/or, wherein:
the component area has a 1-1 component area, a 1-2 component area, and a 1-3 component area,
the 1-3 component area is located closest to the display area, and the 1-1 component area is located furthest from the display area, and
the density or size of the optical sensor area of the 1-1 component area is the largest, the density or size of the optical sensor area of the 1-2 component area has an intermediate value, and the density or size of the optical sensor area of the 1-3 component area has the smallest among the densities or sizes of the optical sensor areas of the 1-1 component area to 1-3 component area.

15. The light emitting display device (1000) of any of claims 11 to 14, wherein:
a buffer area (BUA) is located between the component area (EA) and the display area (DA).
